# EUROPEAN PATENT SPECIFICATION

(11) **EP 3 805 820 B1**
(45) Date of publication and mention of the grant of the patent: **17.04.2024**
(21) Application number: 19811227.8
(22) Date of filing: 22.05.2019
(51) Int. Cl.: G02B 5/20, G03F 7/11, G03F 7/40, G03F 7/42, C09B 23/01, C09B 29/52, C09B 47/04, C09B 57/00

(54) **COLORING COMPOSITION AND METHOD FOR PRODUCING COLOR FILTER FOR USE IN SOLID-STATE IMAGING ELEMENT**
FARBZUSAMMENSETZUNG UND VERFAHREN ZUR HERSTELLUNG EINES FARBFILTERS ZUR VERWENDUNG BEI EINEM FESTKÖRPER-BILDGEBUNGSELEMENT
COMPOSITION COLORANTE ET PROCÉDÉ DE PRODUCTION DE FILTRE COLORÉ DESTINÉ À UNE UTILISATION DANS UN ÉLÉMENT D'IMAGERIE À SEMI-CONDUCTEURS

(30) Priority: 31.05.2018 JP 2018104882
(43) Date of publication of application: 14.04.2021
(73) Proprietor: Toppan Printing Co., Ltd., Tokyo 1108560 (JP)
(72) Inventor: HIKI Kenji, Tokyo 104-0031 (JP); YAMAKAWA Hiroyuki, Tokyo 104-0031 (JP); HIROTA Tetsuya, Tokyo 110-8560 (JP); KITAZAWA Kazushige, Tokyo 110-8560 (JP)
(74) Representative: TBK
(86) International application number: PCT/JP2019/020358
(87) International publication number: WO 2019/230539

(56) References cited:
- WO-A1-2017/122695
- WO-A1-2017/122695
- JP-A- 2008 250 188
- JP-A- 2012 103 472
- JP-A- 2012 103 472
- US-A1- 2017 146 904
- Michael Chambers: "ChemIDplus - 39317-73-2 - Polyglycerol polyglycidyl ether - Similar structures search, synonyms, formulas, resource links, and other chemical information.", , 3 March 2022 (2022-03-03), XP055897057, Retrieved from the Internet: URL:https://chem.nlm.nih.gov/chemidplus/rn /39317-73-2 [retrieved on 2022-03-03]

## Description

### [Technical Field]

The present invention relates to a coloring composition used for, such as forming a color filter of a solid-state imaging element or the like.

### [Background Art]

In solid-state imaging elements, a color filter in which pixels of plural colors such as red pixels, green pixels, and blue pixels are two-dimensionally arranged are provided on a substrate such as a semiconductor substrate. In such solid-state imaging elements, as the pixel size decreases, performance requirements for color separation become stricter. A color filter for a solid-state imaging element constituting the color filter requires performance such as thinning, rectangularization, and elimination of an overlapping area where colors overlap between pixels to maintain device characteristics such as color shading characteristics and prevention of color mixture.

Specifically, a color filter for a solid-state imaging element requires, for example, a pattern having a thickness of at most 1 µm and a side of at most 2 µm (for example, 0.5 to 2.0 µm).

Particularly in recent years, due to demands for higher definition of a color filter for a solid-state imaging element, an ability of forming a pattern having, for example, a side of at most 1.0 µm is required. For this reason, in a photolithography method, it is difficult to avoid trade-off between resolving power and a thin film of a colored pattern.

On the other hand, it has been proposed to pattern a colored layer through a dry etching method to form pixels (refer to Patent Literatures 1 and 2).

WO2017/122695 A1 relates to a thermosetting coloring composition which is used for the production of a color filter for solid-state imaging elements, said color filter being provided with a color pattern that is obtained by patterning a colored layer by means of dry etching, and which is characterized by containing a pigment (A), a dispersant (B), a thermosetting compound (C) and a solvent (D), while being also characterized in that: the ratio of the pigment (A) relative to the total solid content of the thermosetting coloring composition is 50% by mass or more; the dispersant (B) contains a dispersant (b1) having an acidic functional group and/or a dispersant (b2) having a basic functional group; and the thermosetting compound (C) contains a glycidyl-esterified epoxy compound of sorbitol.

US2017/146904 A1 relates to a coloring composition including a curable compound and a colorant represented by (D-L¹-Y-X-)ₙ-R¹-(R²)ₘ; wherein R1 represents a (m+n)-valent linking group, X represents -C(=O)O-, Y represents an alkylene group, L¹ represents a single bond or a divalent linking group, D represents a colorant structure. R² represents a monovalent substituent, m represents an integer of 1 to 13, n represents an integer of 2 to 14, m+n represents an integer of 3 to 15, L¹ (in a case where L¹ represents a single bond, D) and X are separated by Y by a distance of three or more carbon atoms, and at least one of D, L¹, R¹, R², X, or Y has an acid group.

JP2012-103472 A relates to a coloring composition at least including a solvent, a pigment and a crosslinking agent, wherein the pigment includes a phthalocyanine pigment, and a compounding ratio of the crosslinking agent and the pigment is 2.0≤the crosslinking agent/the pigment≤6.0.

### [Citation List]

### [Patent Literature]

[Patent Literature 1]
   Japanese Patent Laid-Open No. 2003-332310
[Patent Literature 2]
   Japanese Patent Laid-Open No. 2008-216970

### [Summary of Invention]

### [Technical Problem]

However, in the dry etching method, it is necessary to peel off a photoresist formed on a colored layer using a stripping liquid. At this time, there is a problem in that the colored layer is damaged due to the stripping liquid.

In addition, when a thermosetting compound is used for improving resistance to the stripping liquid, there is a problem in that storage stability deteriorates and a foreign substance is generated in a coloring composition.

The present invention provides a coloring composition which is capable of forming a colored layer having excellent resistance to a stripping liquid and has favorable storage stability, and a production method for a color filter for a solid-state imaging element in which the coloring composition is used.

### [Solution to Problem]

The present invention provides a coloring composition according to the appended claims <1> to <5>, and a production method for a color filter for a solid-state imaging element according to the appended claims <6> to <8>.

### [Advantageous Effects of Invention]

According to the present invention, it is possible to provide a coloring composition which is capable of forming a colored layer having excellent resistance to a stripping liquid and has favorable storage stability, and a production method for a color filter for a solid-state imaging element in which the coloring composition is used.

### [Brief Description of Drawings]

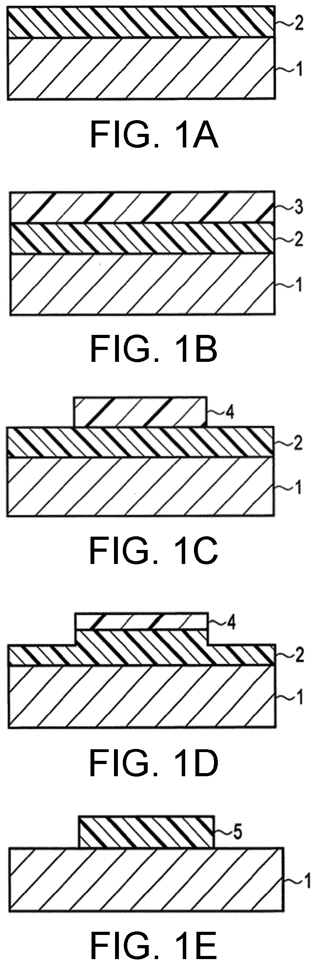

Fig. 1A is a schematic process diagram showing an example of a forming method for patterning through dry etching, and is a cross-sectional view showing a state in which a colored layer is formed on a base material.
Fig. 1B is a schematic process diagram showing an example of a forming method for patterning through dry etching, and is a cross-sectional view showing a state in which a photoresist layer is formed on the colored layer.
Fig. 1C is a schematic process diagram showing an example of a forming method for patterning through dry etching, and is a cross-sectional view showing a state in which the photoresist layer is patterned.
Fig. 1D is a schematic process diagram showing an example of a forming method for patterning through dry etching, and is a cross-sectional view showing a state during development.
Fig. 1E is a schematic process diagram showing an example of a forming method for patterning through dry etching, and is a cross-sectional view showing a state in which a colored pattern is formed.

### [Description of Embodiments]

Hereinafter, the details of an embodiment of the present invention will be described.

In the present specification, unless otherwise specified, "(meth)acryloyl" refers to "acryloyl and/or methacryloyl," "(meth)acryl" refers to "acryl and/or methacryl," "(meth)acrylic acid" refers to "acrylic acid and/or methacrylic acid," "(meth)acrylate" refers to "an acrylate and/or a methacrylate," and "(meth)acrylamide" refers to "acrylamide and/or methacrylamide."

"C.I." in the present specification means a color index (C.I.).

In addition, "color filter for a solid-state imaging element" in the present specification means a color filter which includes a colored layer formed in a predetermined pattern shape and is used for a solid-state imaging element.

A coloring composition of the present embodiment includes: an organic pigment (A); a dispersant (B); an epoxy compound (C); a solvent (D); and a coloring matter derivative (E), in which a proportion of the pigment (A) in the total solid content of the coloring composition is at least 50 mass%, the dispersant (B) contains a dispersant (b1) having an acidic functional group and/or a dispersant (b2) having a basic functional group, and the epoxy compound (C) is at least one compound selected from the group consisting of glycerol polyglycidyl ether, bisphenol-type polyglycidyl ether, and hydrogenated bisphenol-type polyglycidyl ether.

A resin composition capable of forming a colored layer having excellent resistance to a stripping liquid is obtained by using the above-described specific dispersant (B), the above-described specific epoxy compound (C), and the coloring matter derivative (E) in combination.

The resin composition of the present embodiment contains at least the organic pigment (A), the dispersant (B), the epoxy compound (C), the solvent (D), and the coloring matter derivative (E), and may further contain other components as necessary.

Hereinafter, each component of such a resin composition will be described.

### <Organic Pigment (A)>

The above-described organic pigment (A) adjusts a colored layer to have a desired color tone, and well-known organic pigments can be used alone or in combination of two or more thereof. Plural organic pigments such as red pigments, blue pigments, green pigments, yellow pigments, and violet pigments may be combined as the organic pigment (A). As the organic pigments, for example, diketopyrrolopyrrole pigments; azo pigments such as azo, disazo, and polyazo; anthraquinone pigments such as aminoanthraquinone, diaminodianthraquinone, anthrapyrimidine, flavanthrone, anthanthrone, indanthrone, pyranthrone, and violanthrone; quinacridone pigments; perinone pigments; perylene pigments; thioindigo pigments; isoindoline pigments; isoindolinone pigments; quinophthalone pigments; threne pigments; and metal complex pigments and so on can be enumerated.

As red pigments mainly for a red colored layer, for example, C.I. Pigment Red 1, 2, 3, 4, 5, 6, 7, 8, 9, 12, 14, 15, 16, 17, 21, 22, 23, 31, 32, 37, 38, 41, 47, 48, 48:1, 48:2, 48:3, 48:4, 49, 49:1, 49:2, 50:1, 52:1, 52:2, 53, 53:1, 53:2, 53:3, 57, 57:1, 57:2, 58:4, 60, 63, 63:1, 63:2, 64, 64:1, 68, 69, 81, 81:1, 81:2, 81:3, 81:4, 83, 88, 90:1, 101, 101:1, 104, 108, 108:1, 109, 112, 113, 114, 122, 123, 144, 146, 147, 149, 151, 166, 168, 169, 170, 172, 173, 174, 175, 176, 177, 178, 179, 181, 184, 185, 187, 188, 190, 193, 194, 200, 202, 206, 207, 208, 209, 210, 214, 216, 220, 221, 224, 230, 231, 232, 233, 235, 236, 237, 238, 239, 242, 243, 245, 247, 249, 250, 251, 253, 254, 255, 256, 257, 258, 259, 260, 262, 263, 264, 265, 266, 267, 268, 269, 270, 271, 272, 273, 274, 275, and 276 and so on can be enumerated.

As orange pigments used alone or in combination with red pigments , for example, C.I. Pigment Orange 36, 38, 43, 51, 55, 59, and 61 and so on can be enumerated.

Among these, C.I. Pigment Red 254 and 177 are preferable from the viewpoint of high coloring power.

As blue pigments mainly for a blue colored layer, for example, C.I. Pigment Blue 1, 1:2, 9, 14, 15, 15:1, 15:2, 15:3, 15:4, 15:6, 16, 17, 19, 25, 27, 28, 29, 33, 35, 36, 56, 56:1, 60, 61, 61:1, 62, 63, 66, 67, 68, 71, 72, 73, 74, 75, 76, 78 and 79 and so on can be enumerated. Among these, C.I. Pigment Blue 15, 15:1, 15:2, 15:3, 15:4, or 15:6 is preferable and C.I. Pigment Blue 15:3 or 15:6 is more preferable from the viewpoint of high coloring power.

As green pigments mainly for a green colored layer, for example, C.I. Pigment Green 1, 2, 4, 7, 8, 10, 13, 14, 15, 17, 18, 19, 26, 36, 45, 48, 50, 51, 54, 55, 58, 59, 62, and 63 and so on can be enumerated. Among these, C.I. Pigment Green 7, 36, or 58 is preferable from the viewpoint of high coloring power.

As yellow pigments used in combination with red pigments, blue pigments, or green pigments, for example, C.I. Pigment Yellow 1, 1:1, 2, 3, 4, 5, 6, 9, 10, 12, 13, 14, 16, 17, 24, 31, 32, 34, 35, 35:1, 36, 36:1, 37, 37:1, 40, 41, 42, 43, 48, 53, 55, 61, 62, 62:1, 63, 65, 73, 74, 75, 81, 83, 87, 93, 94, 95, 97, 100, 101, 104, 105, 108, 109, 110, 111, 116, 117, 119, 120, 126, 127, 127:1, 128, 129, 133, 134, 136, 138, 139, 142, 147, 148, 150, 151, 153, 154, 155, 157, 158, 159, 160, 161, 162, 163, 164, 165, 166, 167, 168, 169, 170, 172, 173, 174, 175, 176, 180, 181, 182, 183, 184, 185, 188, 189, 190, 191, 191:1, 192, 193, 194, 195, 196, 197, 198, 199, 200, 202, 203, 204, 205, 206, 207, 208, and 231 and so on can be enumerated. Among these, C.I. Pigment Yellow 83, 117, 129, 138, 139, 150, 154, 155, 180, 185, or 231 is preferable, and C.I. Pigment Yellow 83, 138, 139, 150, 185 or 231 is more preferable from the viewpoint of high coloring power.

As violet pigments used alone or in combination with blue pigments, for example, C.I. Pigment Violet 1, 1:1, 2, 2:2, 3, 3:1, 3:3, 5, 5:1, 14, 15, 16, 19, 23, 25, 27, 29, 31, 32, 37, 39, 42, 44, 47, 49 and 50 and so on can be enumerated. Among these, C.I. Pigment Violet 19 or 23 is preferable, and C.I. Pigment Violet 23 is more preferable from the viewpoint of high coloring power.

It is preferable that the coloring composition of the present embodiment be a green coloring composition containing a green pigment (a1) as the organic pigment (A), and it is more preferable that the green pigment (a1) contain at least one selected from Pigment Green 7, Pigment Green 36, and Pigment Green 58.

The content of the organic pigment (A) to the total amount of non-volatile components in this coloring composition is at least 50 mass% and preferably 60 to 85 mass% from the viewpoint of obtaining sufficient color characteristics. When the content of the organic pigment (A) is at least 50 mass%, sufficient color characteristics can be obtained. In addition, when the content thereof is at most 85 mass%, the content of the dispersant (B) or the like can relatively increase, whereby excellent stability of the coloring composition is obtained.

The non-volatile components are components that remain when a colored layer is formed, and are components other than the solvent (D).

### (Micronization of Pigments)

The organic pigment (A) is preferably micronized. A micronization method can be appropriately selected. For example, any of wet grinding, dry grinding, and a dissolution-precipitation method may be used, and a salt milling treatment through a kneading method which is a type of wet grinding may be used as will be exemplified below. The primary particle diameter of a pigment is preferably at least 20 nm from the viewpoint of favorable dispersion in a coloring composition. In addition, the primary particle diameter of a pigment is preferably at most 100 nm from the viewpoint of obtaining a colored pattern having a high contrast ratio. A particularly preferable range is a range of 25 to 85 nm. The primary particle diameter of a pigment is obtained through a method of directly measuring the size of primary particles from an electron micrograph of the pigment taken by a transmission electron microscope (TEM). Specifically, the minor axes and the major axes of about 20 primary particles of pigments are measured, and the average is taken as the particle diameter of the pigment particles. Next, the volume of each of 100 or more pigment particles is obtained by approximating it to a cube of the obtained particle diameter, and the volume average particle diameter is defined as an average primary particle diameter.

The salt milling treatment is a treatment in which a mixture of a pigment, a water-soluble inorganic salt, and a water-soluble organic solvent is mechanically kneaded using a kneading machine such as a kneader, a two-roll mill, a three-roll mill, a ball mill, an attritor, or a sand mill while applying heat thereto, and then the water-soluble inorganic salt and the water-soluble organic solvent are removed by washing with water. The water-soluble inorganic salt acts as a crushing aid, and the high hardness of the inorganic salt is utilized to crush pigments. By optimizing the conditions when performing the salt milling treatment of pigments, it is possible to obtain pigments having an extremely fine primary particle diameter and a sharp particle size distribution with a narrow distribution width.

As the water-soluble inorganic salt, sodium chloride, barium chloride, potassium chloride, and sodium sulfate and so on can be enumerated. Among these, sodium chloride (table salt) is preferably used from the viewpoint of price. The water-soluble inorganic salt is, based on 100 parts by mass of a pigment to be treated, preferably 50 to 2,000 parts by mass and more preferably 300 to 1,000 parts by mass from the viewpoints of both treatment efficiency and production efficiency.

The water-soluble organic solvent moistens pigments and a water-soluble inorganic salt, and is appropriately selected from those which dissolve in (mix with) water, and do not substantially dissolve the used inorganic salt. However, since the temperature increases during salt milling and the solvent is easily evaporated, the water-soluble organic solvent is preferably a high-boiling-point solvent having a boiling point of at least 120°C from the viewpoint of suppressing the evaporation of the solvent. As the high-boiling-point solvent, for example, 2-methoxyethanol, 2-butoxyethanol, 2-(isopentyloxy)ethanol, 2-(hexyloxy)ethanol, diethylene glycol, diethylene glycol monoethyl ether, diethylene glycol monobutyl ether, triethylene glycol, triethylene glycol monomethyl ether, liquid-like polyethylene glycol, 1-methoxy-2-propanol, 1-ethoxy-2-propanol, dipropylene glycol, dipropylene glycol monomethyl ether, dipropylene glycol monoethyl ether, and liquid-like polypropylene glycol and so on can be enumerated. The water-soluble organic solvent is, based on 100 parts by mass of a pigment to be treated, preferably 5 to 1,000 parts by mass and more preferably 50 to 500 parts by mass.

When a pigment is subjected to a salt milling treatment, a resin may be added thereto as necessary. The type of the resin is not particularly limited, and a natural resin, a modified natural resin, a synthetic resin, and a synthetic resin modified with a natural resin and so on can be enumerated. The resin is preferably solid at room temperature and water-insoluble, and more preferably partially soluble in the above-described organic solvent. The amount of resin used is preferably 5 to 200 parts by mass based on 100 parts by mass of a pigment to be treated.

### <Other Colorants>

The coloring composition of the present embodiment may contain colorants other than the organic pigment (A). As the other colorants, well-known inorganic pigments or dyes and so on can be enumerated, and the other colorants are used alone or in combination of two or more thereof.

### (Inorganic Pigments)

As the inorganic pigments, for example, a metal oxide powder such as barium sulfate, zinc white, lead sulfate, yellow lead, zinc yellow, red iron oxide (red iron(III) oxide), cadmium red, ultramarine blue, iron blue, chromium oxide green, cobalt green, umber, titanium black, synthetic iron black, titanium oxide, or triiron tetraoxide; a metal sulfide powder; and a metal powder and so on can be enumerated. The inorganic pigments are used in combination with the organic pigment (A) to secure favorable coatability, sensitivity, developability, and the like while balancing saturation and brightness.

### (Dyes)

As dyes, for example, acidic dyes, direct dyes, basic dyes, salt-forming dyes, oil-soluble dyes, dispersed dyes, reactive dyes, mordant dyes, vat dyes, and sulfur dyes and so on can be enumerated.

Dyes also include the form of lake pigments (salt-forming compounds) obtained by forming lakes of dyes or dye derivatives.

In a case where the above-described dyes are direct dyes or acidic dyes, such as sulfonic acids or carboxylic acids, having an acidic group, the dyes are preferably used in the forms of inorganic salts, salt-forming compounds, or sulfonic acid amide compounds obtained by sulfonamidating sulfonic acids from the viewpoint of improving various resistances of the dyes. A coloring composition having excellent fastness can be obtained by using the dyes.

As the above-described salt-forming compounds, salt-forming compounds with nitrogen-containing compounds such as quaternary ammonium salt compounds, tertiary amine compounds, secondary amine compounds, or primary amine compounds; and salt-forming compounds with compounds having an onium base and so on can be enumerated. A resin having a cationic group in its side chain is preferable among the compounds having an onium base from the viewpoint of fastness.

In a case where the above-described dyes are basic dyes, salt formation may be carried out using organic acids or perchloric acid, or metal salts thereof. Salt-forming compounds of basic dyes are preferable from the viewpoint of excellent resistance and compatibility with pigments. Among salt-forming compounds of basic dyes, salt-forming compounds obtained by forming salts with organic sulfonic acids, organic sulfuric acid, fluorine-group-containing phosphorus anion compounds, fluorine-group-containing boron anion compounds, cyano-group-containing nitrogen anion compounds, anion compounds having a conjugate base of an organic acid having a halogenated hydrocarbon group, or acidic dyes are more preferable.

In addition, dyes may have a polymerizable unsaturated group in the skeleton. Dyes having polymerizable unsaturated groups are preferable from the viewpoint of excellent resistance.

In addition, dyes may have an oxetane group. A coloring composition containing dyes having an oxetane group has excellent heat resistance after curing. Dyes having an oxetane group can be obtained, for example, by using a resin containing an ethylenically unsaturated monomer containing an oxetane structure as a constitutional unit as a resin constituting salt-forming compounds of dyes.

As chemical structures of dyes, for example, coloring matter structures derived from dyes selected from azo dyes, azomethine dyes (such as indoaniline dyes and indophenol dyes), dipyrromethene dyes, quinone dyes (such as benzoquinone dyes, naphthoquinone dyes, anthraquinone dyes, and anthrapyridone dyes), carbonium dyes (such as diphenylmethane dyes, triphenylmethane dyes, diarylmethane dyes, triarylmethane dyes, xanthene dyes, and acridine dyes), quinoneimine dyes (such as oxazine dyes and thiazine dyes), azine dyes, polymethine dyes (such as oxonol dyes, merocyanine dyes, arylidene dyes, styryl dyes, cyanine dyes, squarylium dyes, and croconium dyes), quinophthalone dyes, phthalocyanine dyes, subphthalocyanine dyes, perinone dyes, indigo dyes, thioindigo dyes, quinoline dyes, nitro dyes, nitroso dyes, methine dyes, cationic dyes, perylene dyes, diketopyrrolopyrrole dyes, quinacridone dyes, anthanthrone dyes, isoindolinone dyes, isoindoline dyes, indanthrone dyes, coumarin dyes, pyranthrone dyes, flavanthrone dyes, and metal complex dyes thereof and so on can be enumerated. Regarding specific dyes, for example, dyes disclosed in "New Dye Handbook" (edited by The Society of Synthetic Organic Chemistry, Japan, Maruzen, 1970), "Color Index" (The Society of Dyers and colourists), and "Coloring Matter Handbook" (edited by Okawara et al.; Kodansha Ltd., 1986) and so on can be referred to as.

### <Dispersant (B)>

The coloring composition of the present embodiment contains a dispersant (b 1) having an acidic functional group and/or a dispersant (b2) having a basic functional group as a dispersant (B). With the dispersant, the dispersion stability of the organic pigment (A) in the coloring composition becomes more favorable, and a composition having excellent viscosity stability is obtained. In addition, since pigments are favorably dispersed, uniformity of a coating film improves, resistance to a stripping liquid increases, and a composition suitable for a production method for a color filter through dry etching is obtained.

Furthermore, since the dispersant (B) has an acidic functional group and/or a basic functional group, a cross-linking reaction between the dispersant (B) and an epoxy compound (C) to be described below is promoted. For this reason, according to the coloring composition of the present embodiment, a colored layer having excellent resistance to a stripping liquid can be obtained.

Dispersants usually have a colorant-affinity region that adsorbs onto a colorant and a solvent-affinity region that has compatibility with a solvent, and adsorb onto a colorant to stabilize dispersion in a solvent.

### (Dispersant (b1) Having Acidic Functional Group and Dispersant (b2) Having Basic Functional Group)

In the coloring composition, the dispersant (B) has at least one of the dispersant (b1) having an acidic functional group and the dispersant (b2) having a basic functional group. In the present embodiment, the acidic functional group contained in the dispersant (b1) and the basic functional group contained in the dispersant (b2) usually function as pigment-affinity regions and improve dispersion stability of the organic pigment (A). The dispersant (B) preferably contains the dispersant (b1) having an acidic functional group and the dispersant (b2) having a basic functional group from the viewpoint that the viscosity of a dispersion becomes low and the viscosity stability becomes excellent with addition of a small amount.

The dispersant (B) in the present embodiment is preferably a resin dispersant from the viewpoint of compatibility in the coloring composition.

As the resin dispersant, polyurethanes, polycarboxylic acid esters such as polyacrylates, unsaturated polyamides, polycarboxylic acids, (partial) amine salts of polycarboxylic acids, polycarboxylic acid ammonium salts, polycarboxylic acid alkylamine salts, polysiloxane, long-chain polyaminoamide phosphates, hydroxyl-group-containing polycarboxylic acid esters, or modified products thereof; oil dispersants such as an amide or a salt thereof formed through a reaction of poly(lower alkylene)imine and polyester having a free carboxyl group; water-soluble polymer compounds or water-soluble resins such as (meth)acrylic acid-styrene copolymers, (meth)acrylic acid-(meth)acrylic acid ester copolymers, and styrene-maleic acid copolymers, polyvinyl alcohol, and polyvinyl pyrrolidone; polyester compounds; modified polyacrylate compounds; ethylene oxide/propylene oxide addition compounds; and phosphate ester compounds can be specifically enumerated. These can be used alone or in combination of two or more thereof.

The total ratio of the dispersant (b1) having an acidic functional group and the dispersant (b2) having a basic functional group to the total amount of dispersant (B) is, for example, within a range of 80 mass% to 100 mass% and preferably within a range of 90 mass% to 100 mass%.

According to an example, the ratio of the dispersant (b1) having an acidic functional group to the total amount of the dispersant (b1) having an acidic functional group and the dispersant (b2) having a basic functional group is at least 30 mass% and preferably at least 50 mass%. According to another example, the ratio is within a range of 20 mass% to 80 mass% and preferably within a range of 30 mass% to 70 mass%.

Nitrogen-atom-containing graft copolymers, or nitrogen-atom-containing acryl-based block copolymers and urethane-based polymer dispersants which have a functional group containing a tertiary amino group, a quaternary ammonium base, a nitrogen-containing heterocycle, and the like in their side chains are preferable as the dispersant (b2) having a basic functional group.

Acryl-based copolymers, acryl-based block copolymers, and urethane-based polymer dispersants which have a functional group containing a carboxylic acid group, a phosphoric acid group, a sulfonic acid group, and the like are preferable as the dispersant (b1) having an acidic functional group. The dispersant (b1) having an acidic functional group has a region (b1-A) formed by polymerizing an ethylenically unsaturated monomer containing a (meth)acrylate. A theoretical value of a glass transition temperature of the region (b1-A) is preferably at least 40°C and more preferably at least 80°C from the viewpoint of improving resistance to a stripping liquid of an obtained colored layer. Furthermore, a dispersant (b11) having an aromatic carboxyl group is preferable as the dispersant (b1) having an acidic functional group. According to the dispersant (b11) having an aromatic carboxyl group, the resistance to a stripping liquid of an obtained colored layer improves.

The dispersant (b11) having an aromatic carboxyl group has an aromatic carboxyl group in its molecule. In production methods for the dispersant (b11), a production method (1) in which an aromatic tricarboxylic acid anhydride (F1) and/or an aromatic tetracarboxylic acid dianhydride (F2) are reacted with a polymer (G) having a hydroxyl group; a production method (2) in which a polymer is produced using a monomer having an aromatic carboxyl group; and a production method (3) in which the aromatic tricarboxylic acid anhydride (F1) and/or the aromatic tetracarboxylic acid dianhydride (F2) are reacted with a monomer having a hydroxyl group while polymerizing the monomer and so on can be enumerated. Among these, the production method (1) in which the number of aromatic carboxyl groups in the dispersant (B) is easily controlled is preferable from the viewpoint of pigment dispersibility.

That is, the dispersant (b11) having an aromatic carboxyl group is preferably a dispersant obtained by reacting the polymer (G) having a hydroxyl group with the aromatic tricarboxylic acid anhydride (F1) and/or the aromatic tetracarboxylic acid dianhydride (F2). Among these, the polymer (G) having a hydroxyl group is more preferably a polymer having a hydroxyl group at one terminal, and the polymer (G) having a hydroxyl group at one terminal is more preferably a polymer having two hydroxyl groups at one terminal. A coloring composition having excellent stability can be obtained by using such a dispersant.

In addition, the polymer having a hydroxyl group at one terminal is preferably a polyester and/or polyether-based polymer having a hydroxyl group at one terminal or a vinyl-based polymer having a hydroxyl group at one terminal, and is more preferably a vinyl-based polymer having a hydroxyl group at one terminal from the viewpoint of dispersion stability.

In addition, regarding the aromatic tricarboxylic acid anhydride (F1) and/or the aromatic tetracarboxylic acid dianhydride (F2), the aromatic tetracarboxylic acid dianhydride (F2) is preferable from the viewpoint of excellent storage stability of a pigment dispersion.

As methods for obtaining the dispersant (b11) having an aromatic carboxyl group, for example, a method in which a hydroxyl group in a polyol (g1) containing at least a vinyl polymer (g12) which is obtained by subjecting an ethylenically unsaturated monomer to radical polymerization in the presence of a compound (g11) having two hydroxyl groups and one thiol group in its molecule and has two hydroxyl groups at one terminal is reacted with an acid anhydride group in a polycarboxylic acid anhydride (f) containing at least the aromatic tetracarboxylic acid dianhydride (F2) can be enumerated.

Among the above-described dispersants (b11) having an aromatic carboxyl group, dispersants containing methyl methacrylate as a constituent monomer of a vinyl polymer (g12) region are preferable from the viewpoint of improving resistance to a stripping liquid. The content of methyl methacrylate in a polymer is preferably at least 30 %, more preferably at least 50%, and still more preferably at least 65% by mass ratio. In a case where the content thereof is less than 30%, the resistance to a stripping liquid may sometimes deteriorate.

Regarding the dispersant (b11) having an aromatic carboxyl group, well-known techniques disclosed in PCT International Publication No. WO2008/007776, Japanese Patent Laid-Open No. 2009-185277, and Japanese Patent Laid-Open No. 2008-029901 can be used.

As commercially available dispersants (b1) having an acidic functional group, Disperbyk-101, 110, 111, 130, 140, 170, 171, 174, 180, 2001, 2020, 2025, and 2070, or BYK-P104, P104S, and 220S manufactured by BYK-Chemie Japan; SOLSPERSE-3000, 13240, 13650, 13940, 16000, 17000, 18000, 21000, 24000, 26000, 27000, 28000, 31845, 32000, 32500, 32550, 32600, 34750, 35100, 36600, 38500, 41000, 41090, 53095, and 55000 manufactured by Lubrizol Japan Ltd.; EFKA-4008, 4009, 4010, 4406, 5010, 5065, 5066, and 5070 manufactured by BASF SE; and Ajisper PA111, PB821, and PB822 manufactured by Ajinomoto Fine-Techno Co., Inc and so on can be enumerated.

As commercially available dispersants (b2) having a basic functional group, Disperbyk-101, 108, 116, 130, 140, 161, 162, 163, 164, 165, 166, 180, 182, 183, 184, 185, 2000, 2001, 2020, 2025, 2050, 2070, and 2150, and BYK-6919 manufactured by BYK-Chemie Japan; SOLSPERSE-13240, 13650, 13940, 20000, 24000, 26000, 31845, 32000, 32500, 32550, 34750, and 35100 manufactured by Lubrizol Japan Ltd.; EFKA-4008, 4009, 4010, 4015, 4020, 4047, 4050, 4055, 4060, 4080, 4400, 4401, 4402, 4403, 4406, 4300, 4330, 4500, 4510, 4530, 4550, 4560, and 4800 manufactured by BASF SE; and Ajisper PB711, PB821, and PB822 manufactured by Ajinomoto Fine-Techno Co., Inc and so on can be enumerated.

The content of dispersant (B) in a coloring composition is preferably 5 to 200 mass% based on the total amount of pigment, and is more preferably 10 to 40 mass% from the viewpoint of film formability.

### <Epoxy Compound (C)>

The coloring composition of the present embodiment contains at least one epoxy compound (C) selected from the group consisting of glycerol polyglycidyl ether, bisphenol-type polyglycidyl ether, and hydrogenated bisphenol-type polyglycidyl ether, as a thermosetting compound.

By incorporating the above-described specific epoxy compound (C), cross-linking proceeds during calcination of a coating film, the resistance to a stripping liquid improves, and the coloring composition can be applied to a production method for a color filter through dry etching. In addition, even if the storage period is expired, no foreign substances are generated in the coloring composition, and a favorable coating film without foreign substances can be obtained.

Glycerol polyglycidyl ether is a bifunctional or trifunctional epoxy compound obtained by reacting a hydroxy group of glycerol with epichlorohydrin, and is a bifunctional glycerol diglycidyl ether represented by Chemical Formula (1) below and a trifunctional glycerol triglycidyl ether represented by Chemical Formula (2). It is assumed that because these glycerol polyglycidyl ethers have a relatively high proportion of epoxy groups per unit mass, the cross-linking density of a colored layer increases and the resistance to a stripping liquid is excellent.

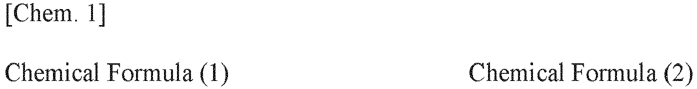

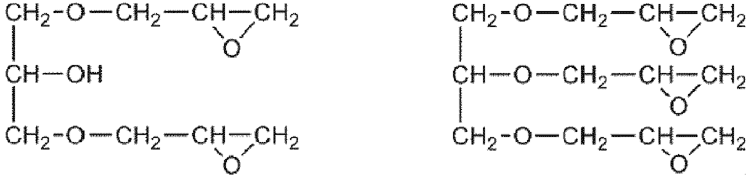

It is assumed that because bisphenol-type polyglycidyl ether and hydrogenated bisphenol-type polyglycidyl ether have a phenol skeleton or a cyclohexane skeleton in their molecules, the glass transition temperature of a coating film after calcination increases and the resistance to a stripping liquid is excellent. In addition, it is assumed that because these are bifunctional, their reactivity is lower than that of tri- or higher functional ethers, and therefore, the storage stability is favorable.

Commercially available products may be used for glycidyl etherified epoxy compounds of glycerol. As the commercially available products, for example, Denacol EX-313 and EX-314 manufactured by Nagase ChemteX Corporation and so on can be enumerated. In addition, commercially available products may be used for bisphenol-type polyglycidyl ether. As of the commercially available products, for example, jER825, jER827, jER828, and jER84 manufactured by Mitsubishi Chemical Corporation, Adeka Resin EP-4100, EP-4300, EP-4400, P-4520S, EP-4530, and EP-4901 manufactured by ADEKA, EPICLON 840, 850, 860, 1050, 1055, and 2050 manufactured by DIC CORPORATION, and Epolight 3002(N) manufactured by KYOEISHA CHEMICAL Co., LTD and so on can be enumerated.

In addition, commercially available products may be used for hydrogenated bisphenol-type polyglycidyl ether. As the commercially available products, for example, Denacol EX-252 manufactured by Nagase ChemteX Corporation, Rikaresin HBE-100 manufactured by New Japan Chemical Co., Ltd., and ST-3000 and ST-4000D manufactured by Nippon Steel & Sumitomo Metal Corporation and so on can be enumerated.

### (Other Thermosetting Compounds)

Other thermosetting compounds may be used in combination in the coloring composition of the present embodiment. When other thermosetting compounds are used, the content thereof is preferably 1 mass% to 20 mass% and more preferably 5 mass% to 10 mass% based on the total amount of thermosetting compounds containing the epoxy compound (C). In the present embodiment, thermosetting compounds may be composed of the epoxy compound (C).

As the above-described other thermosetting compounds, for example, epoxy compounds other than the epoxy compound (C), benzoguanamine compounds, rosin-modified maleic acid compounds, rosin-modified fumaric acid compounds, melamine compounds, urea compounds, cardo compounds, and phenol compounds and so on can be enumerated, but the present invention is not limited thereto. Among these, epoxy compounds other than the epoxy compound (C) are preferable. Cross-linking proceeds during calcination of a coating film in which the coloring composition of the present embodiment is used, and the resistance to a stripping liquid improves.

As commercially available epoxy compounds other than the epoxy compound (C), for example, Epikote 807, Epikote 815, Epikote 825, Epikote 827, Epikote 828, Epikote 190P, Epikote 191P, Epikote 1004, and Epikote 1256 (all of which are trade names; manufactured by Mitsubishi Chemical Corporation), TECHMORE VG3101L (trade name; manufactured by Mitsui Chemicals, Inc.), EPPN-501H and 502H (trade names; manufactured by Nippon Kayaku Co., Ltd.) JER 1032H60, JER 157S65, and 157S70 (trade names; manufactured by Mitsubishi Chemical Corporation), EPPN-201 (trade name, Nippon Kayaku Co., Ltd.), JER152 and JER154 (both of which are trade names; manufactured by Mitsubishi Chemical Corporation), EOCN-102S, EOCN-103S, EOCN-104S, and EOCN-1020 (all of which are trade names; manufactured by Nippon Kayaku Co., Ltd.), CELLOXIDE 2021 and EHPE-3150 (both of which are trade names; manufactured by Daicel Corporation), and Denacol EX-321, EX-810, EX-830, EX-851, EX-611, EX-612, EX-614, EX-521, EX-512, EX-411, EX-421, EX-201, and EX-111 (all of which are trade names; manufactured by Nagase ChemteX Corporation) and so on can be enumerated, but the present invention is not limited thereto.

In the coloring composition of the present embodiment, the ratio of the thermosetting compounds to the total amount of non-volatile components is preferably 1 to 30 mass% and more preferably 3 to 20 mass% from the viewpoint of obtaining sufficient thermosetting properties. In a case where the proportion of the curable compound components is at least 1 mass%, a colored layer that is sufficiently cross-linked during calcination can be obtained. On the other hand, in the case where the proportion is at most 30 mass%, the content of organic pigment (A) relatively increases, and sufficient color characteristics can be obtained.

### <Solvent (D)>

The solvent (D) in the coloring composition of the present embodiment is used for dispersing each component such as the organic pigment (A) and the epoxy compound (C). In addition, the solvent (D) is used for facilitating formation of a colored layer by coating a substrate such as a silicon wafer substrate so that a dry film thickness will be 0.2 to 10 µm.

As the solvent, for example, 1,2,3-trichloropropane, 1,3-butanediol, 1,3-butylene glycol, 1,3-butylene glycol diacetate, 1,4-dioxane, 2-heptanone, 2-methyl-1,3-propanediol, 3,5,5-trimethyl-2-cyclohexene-1-one, 3,3,5-trimethylcyclohexanone, ethyl 3-ethoxypropionate, 3-methyl-1,3-butanediol, 3-methoxy-3-methyl-1-butanol, 3-methoxy-3-methylbutyl acetate, 3-methoxybutanol, 3-methoxybutyl acetate, 4-heptanone, m-xylene, m-diethylbenzene, m-dichlorobenzene, N,N-dimethylacetamide, N,N-dimethylformamide, n-butyl alcohol, n-butylbenzene, n-propyl acetate, N-methylpyrrolidone, o-xylene, o-chlorotoluene, o-diethylbenzene, o-dichlorobenzene, p-chlorotoluene, p-diethylbenzene, sec-butylbenzene, tert-butylbenzene, γ-butyrolactone, isobutyl alcohol, isophorone, ethylene glycol diethyl ether, ethylene glycol dibutyl ether, ethylene glycol monoisopropyl ether, ethylene glycol monoethyl ether, ethylene glycol monoethyl ether acetate, ethylene glycol monotertiary butyl ether, ethylene glycol monobutyl ether, ethylene glycol monobutyl ether acetate, ethylene glycol monohexyl ether, ethylene glycol monomethyl ether, ethylene glycol monomethyl ether acetate, diisobutyl ketone, diethylene glycol diethyl ether, diethylene glycol dimethyl ether, diethylene glycol monoisopropyl ether, diethylene glycol monoethyl ether acetate, diethylene glycol monobutyl ether, diethylene glycol monobutyl ether acetate, diethylene glycol monomethyl ether, cyclohexanol, cyclohexanol acetate, cyclohexanone, dipropylene glycol dimethyl ether, dipropylene glycol methyl ether acetate, dipropylene glycol monoethyl ether, dipropylene glycol monobutyl ether, dipropylene glycol monopropyl ether, dipropylene glycol monomethyl ether, diacetone alcohol, triacetin, tripropylene glycol monobutyl ether, tripropylene glycol monomethyl ether, propylene glycol diacetate, propylene glycol phenyl ether, propylene glycol monoethyl ether, propylene glycol monoethyl ether acetate, propylene glycol monobutyl ether, propylene glycol monopropyl ether, propylene glycol monomethyl ether, propylene glycol monomethyl ether acetate, propylene glycol monomethyl ether propionate, benzyl alcohol, methyl isobutyl ketone, methyl cyclohexanol, n-amyl acetate, n-butyl acetate, isoamyl acetate, isobutyl acetate, propyl acetate, and dibasic acid ester and so on can be enumerated.

Such solvents can be used alone or in combination of two or more thereof at an arbitrary rate as necessary.

The solvent can be used within a range of 100 to 10,000 parts by mass, preferably within a range of 500 to 5,000 parts by mass based on 100 parts by mass of the organic pigment (A) in the coloring composition.

### <Coloring Matter Derivative (E)>

The coloring composition of the present embodiment contains a coloring matter derivative , selected among the compounds represented by any one of Formulae (3-1) to (6-5) below.

The coloring matter derivative has a large effect of preventing reaggregation of the organic pigment (A) after dispersion. For this reason, when the coloring matter derivative (E) is used in the coloring composition obtained by dispersing organic pigments in a solvent, spectral characteristics and viscosity stability become favorable. In addition, since the coloring matter derivative (E) has an effect of protecting the surface of pigments having weak solvent resistance, chemical resistance to a stripping liquid for a positive resist used for dry etching becomes favorable.

The coloring matter derivative (E) in the present embodiment is a dispersion aid which is capable of modifying colored compounds such as pigments or dyes and improving dispersion stability or dissolution stability of a colorant such as the organic pigment (A).

In addition, these can be used alone or in combination of two or more thereof.

As coloring matter derivatives, compounds represented by Formulae (3-1) to (6-5) below are used from the viewpoints of viscosity stability and chemical resistance. 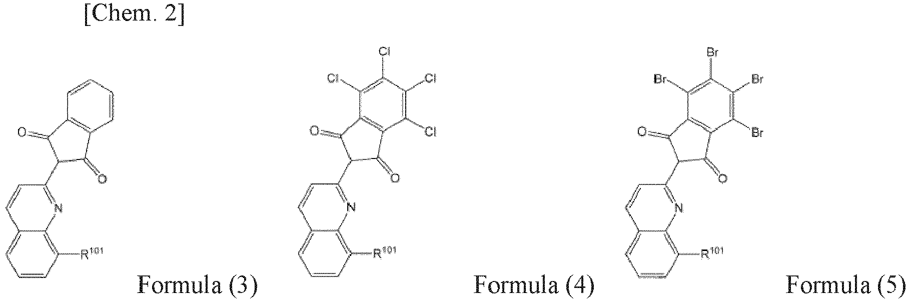 [R¹⁰¹ in Formulae (3) to (5) represents a substituent shown in Table 1 below.]

### [Table 1]

**Table 1**

| | | |
|---|---|---|
| Formula (3-1) | R¹⁰¹= | 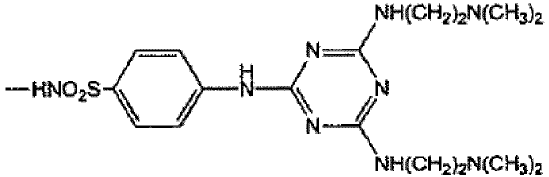 |
| Formula (4-1) | | |
| Formula (5-1) | | |
| Formula (3-2) | R¹⁰¹= | 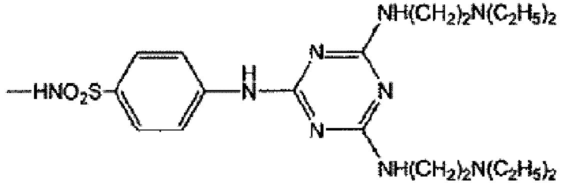 |
| Formula (4-2) | | |
| Formula (5-2) | | |
| Formula (3-3) | R¹⁰¹= | 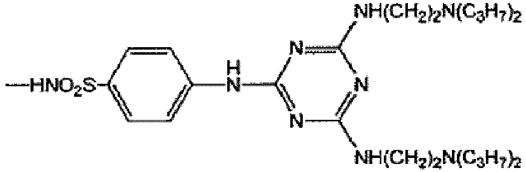 |
| Formula (4-3) | | |
| Formula (5-3) | | |
| Formula (3-4) | R¹⁰¹= | 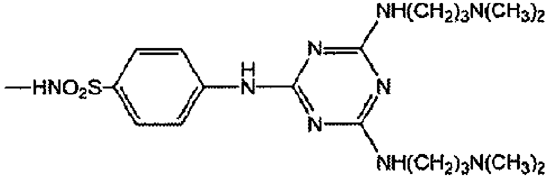 |
| Formula (4-4) | | |
| Formula (5-4) | | |
| Formula (3-5) | R¹⁰¹= | 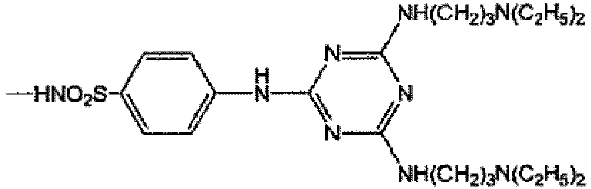 |
| Formula (4-5) | | |
| Formula (5-5) | | |
| Formula (3-6) | R¹⁰¹= | 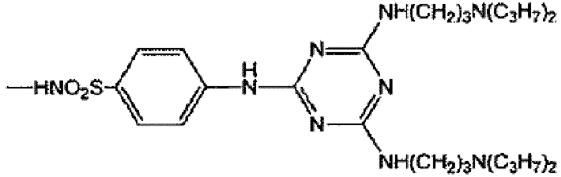 |
| Formula (4-6) | | |
| Formula (5-6) | | |
| Formula (3-7) | R¹⁰¹= | 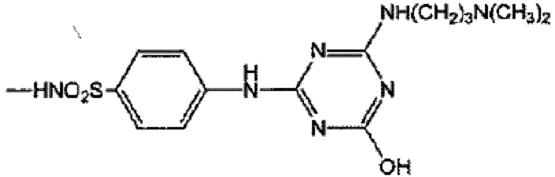 |
| Formula (4-7) | | |
| Formula (5-7) | | |
| Formula (3-8) | R¹⁰¹= | 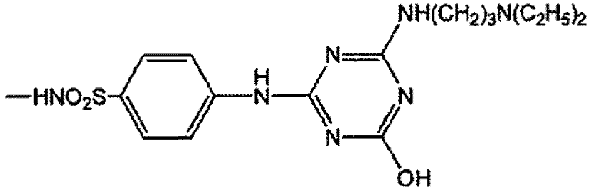 |
| Formula (4-8) | | |
| Formula (5-8) | | |
| Formula (3-9) | R¹⁰¹= | 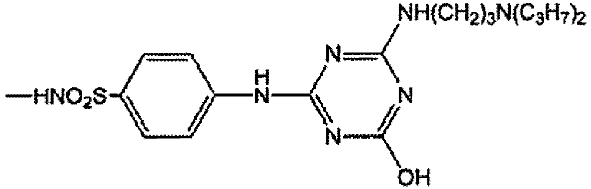 |
| Formula (4-9) | | |
| Formula (5-9) | | |
| Formula (3-10) | R¹⁰¹= | 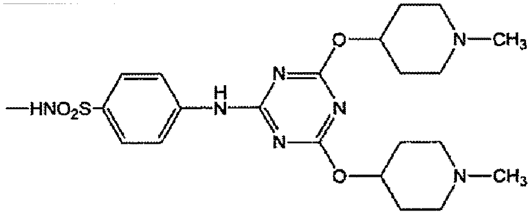 |
| Formula (4-10) | | |
| Formula (5-10) | | |

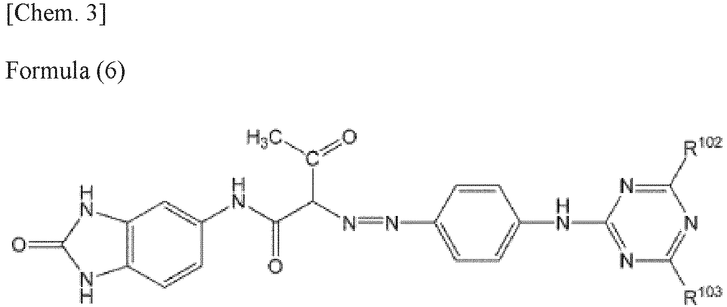

[R¹⁰² and R¹⁰³ in Formula (6) represent substituents shown in Table 2 below.]

### [Table 2]

**Table 2**

| | R¹⁰² | R¹⁰³ |
|---|---|---|
| Formula (6-1) | NH(CH₂)₃N(C₂H₅)₂ | OH |
| Formula (6-2) | NH(CH₂)₃N(C₂H₅)₂ | OCH₃ |
| Formula (6-3) | NH(CH₂)₃N(C₂H₅)₂ | NH(CH₂)₃N(C₂H₅)₂ |
| Formula (6-4) | NH(CH₂)₃N(C₃H₇)₂ | NH(CH₂)₃N(C₃H₇)₂ |
| Formula (6-5) | NH(CH₂)₃N(C₄H₉)₂ | NH(CH₂)₃N(C₄H₉)₂ |

The content of coloring matter derivative in a coloring composition is preferably at least 0.5 parts by mass, more preferably at least 1 part by mass, and still more preferably at least 3 parts by mass based on 100 parts by mass of a pigment from the viewpoint of improving dispersibility of the pigment added. In addition, the content thereof is preferably at most 40 parts by mass and more preferably at most 35 parts by mass based on 100 parts by mass of a pigment from the viewpoints of heat resistance and light resistance.

### <Leveling Agent>

A leveling agent is preferably added to a coloring composition to improve leveling properties of the composition on a transparent substrate. Dimethylsiloxane having a polyether structure or a polyester structure in its main chain is preferable as a leveling agent. As specific examples of dimethylsiloxane having a polyether structure in its main chain, FZ-2122 manufactured by Dow Corning Toray Co., Ltd. and BYK-333 manufactured by BYK-Chemie Japan and so on can be enumerated. AS specific examples of dimethylsiloxane having a polyester structure in its main chain, BYK-310 and BYK-370 manufactured by BYK-Chemie Japan and so on can be enumerated. Dimethylsiloxane having a polyether structure in its main chain and dimethylsiloxane having a polyester structure in its main chain may be used in combination. The content of leveling agent is preferably 0.003 to 1.0 mass% in 100 mass% of the total amount of coloring composition.

A leveling agent, which is a kind of so-called surfactant having a hydrophobic group and a hydrophilic group in its molecule, has a hydrophilic group but has low solubility with respect to water, and has a characteristic of a low surface tension reduction ability when added to a coloring composition, is preferable. Furthermore, a leveling agent having favorable wettability to a glass plate regardless of its low surface tension reduction ability is useful, and a leveling agent capable of sufficiently preventing electrostatic properties with addition of an amount that does not cause defects in a coating film due to bubbling is preferable. As leveling agents having such preferable characteristics include dimethylpolysiloxane having a polyalkylene oxide unit can be enumerated. There is a polyethylene oxide unit and a polypropylene oxide unit as the polyalkylene oxide unit, and dimethylpolysiloxane may have both a polyethylene oxide unit and a polypropylene oxide unit.

In addition, the form of binding of a polyalkylene oxide unit to dimethylpolysiloxane may be any of a pendant type in which a polyalkylene oxide unit is bound with a repeating unit of dimethylpolysiloxane, a terminal-modified type in which a polyalkylene oxide unit is bound to a terminal of dimethylpolysiloxane, and a linear block copolymer type in which a polyalkylene oxide unit is alternately repeatedly bound to dimethylpolysiloxane. Dimethylpolysiloxane having a polyalkylene oxide unit is commercially available from Dow Corning Toray Co., Ltd. For example, FZ-2110, FZ-2122, FZ-2130, FZ-2166, FZ-2191, FZ-2203, and FZ-2207 can be enumerated, but the present invention is not limited thereto.

An anionic, cationic, nonionic, or amphoteric surfactant may be supplementally added to a leveling agent. Two or more surfactants may be used in combination.

As anionic surfactants that can be supplementally added to a leveling agent, polyoxyethylene alkyl ether sulfates, sodium dodecylbenzene sulfonates, alkali salts of styrene-acrylic acid copolymers, sodium alkyl naphthalene sulfonates, sodium alkyl diphenyl ether disulfonates, monoethanolamine lauryl sulfate, triethanolamine lauryl sulfate, ammonium lauryl sulfate, monoethanolamine stearate, sodium stearate, sodium lauryl sulfate, monoethanolamine of styrene-acrylic acid copolymers, and polyoxyethylene alkyl ether phosphoric acid esters and so on can be enumerated.

As cationic surfactants that can be supplementally added to a leveling agent, alkyl quaternary ammonium salts or ethylene oxide adducts thereof can be enumerated. As nonionic surfactants that can be supplementally added to a leveling agent, amphoteric surfactants such as polyoxyethylene oleyl ether, polyoxyethylene lauryl ether, polyoxyethylene nonyl phenyl ether, polyoxyethylene alkyl ether phosphoric acid esters, and polyoxyethylene sorbitan monostearate, and polyethylene glycol monolaurate; amphoteric surfactants such as alkylimidazolines and alkylbetaines such as alkyl dimethyl aminoacetic acid betaines; and fluorine or silicone surfactants can be enumerated.

### <Production Method for Coloring Composition>

The coloring composition (pigment dispersion) of the present embodiment can be produced by, for example, finely dispersing the organic pigment (A) in the solvent (D) together with the dispersant (B), the coloring matter derivative (E), the following dispersion aids, or the like as necessary using various dispersion means such as a kneader, a two-roll mill, a three-roll mill, a ball mill, a horizontal sand mill, a vertical sand mill, an annular bead mill, or an attritor. At this time, two or more organic pigments or the like may be simultaneously dispersed in the solvent, or two or more organic pigments which have been separately dispersed in the solvent may be mixed with each other.

In a case where other colorants, such as dyes, having high solubility are used in combination, it is unnecessary to finely disperse the colorants as described above to produce the coloring composition as long as, for specific example, the colorants have high solubility in a solvent to be used and are dissolved through stirring, and no foreign substance is visible.

In the coloring composition of the present embodiment, it is preferable to remove 5 µm or larger coarse particles, preferably 1 µm or larger coarse particles, and more preferably 0.5 µm or larger coarse particles, and dust mixed in, through centrifugation at a gravitational acceleration of 3,000 to 25,000 G using means such as a sintering filter or a membrane filter after carrying out the above-described dispersion.

### (Dispersion Aid)

When dispersing the organic pigment (A) in the solvent (D), a surfactant or the like may be appropriately used in addition to the coloring matter derivative (E) as a dispersion aid. Since dispersion aids have a large effect of preventing reaggregation of organic pigments after dispersion, a coloring composition obtained by dispersing organic pigments in a solvent using dispersion aids has favorable spectral characteristics and viscosity stability.

As surfactants, for example, anionic surfactants such as sodium lauryl sulfate, polyoxyethylene alkyl ether sulfates, sodium dodecylbenzene sulfonates, alkali salts of styrene-acrylic acid copolymers, sodium stearate, sodium alkyl naphthalene sulfonates, sodium alkyl diphenyl ether disulfonates, monoethanolamine lauryl sulfate, triethanolamine lauryl sulfate, ammonium lauryl sulfate, monoethanolamine stearate, monoethanolamine of styrene-acrylic acid copolymers, and polyoxyethylene alkyl ether phosphoric acid esters; nonionic surfactants such as polyoxyethylene oleyl ether, polyoxyethylene lauryl ether, polyoxyethylene nonyl phenyl ether, polyoxyethylene alkyl ether phosphoric acid esters, polyoxyethylene sorbitan monostearate, and polyethylene glycol monolaurate; cationic surfactants such as alkyl quaternary ammonium salts or ethylene oxide adducts thereof; and amphoteric surfactants such as alkylimidazolines and alkylbetaines such as alkyl dimethyl aminoacetic acid betaines and so on can be enumerated, and these can be used alone or in combination of two or more thereof.

The formulation amount in case where surfactant is added is preferably 0.1 to 55 mass% and more preferably 0.1 to 45 mass% when the total amount of colorant is 100 mass%. When the formulation amount of surfactant is at least 0.1 mass%, the dispersibility of the organic pigment (A) improves. Meanwhile, a sufficient formulation amount of surfactant is at most 55 mass%. When the formulation amount is at most 55 mass%, the proportion of the organic pigment (A) can be relatively increased.

### [Production Method for Color Filter for Solid-state Imaging Element]

The production method for a color filter for a solid-state imaging element of the present embodiment includes: a step (X) of forming a colored layer using the coloring composition; and a step (Y) of patterning the colored layer through dry etching.

In the above-described production method of the present embodiment, the patterning step (Y) through dry etching is a method for forming a resist pattern on a colored layer to perform patterning by transferring a desired pattern shape to the colored layer through dry etching using the resist pattern as a mask.

The production method of the present embodiment will be described with reference to Figs. 1A to 1E. Figs. 1A to 1E are schematic process diagrams showing an example of a forming method for patterning through dry etching. In the example in Figs. 1A to 1E, a coating film is formed by coating a base material 1 with the coloring composition according to the present invention, and then a colored layer 2 is formed through heating (Fig. 1A). Subsequently, a photoresist layer 3 is formed on the colored layer 2 (Fig. 1B). Subsequently, the photoresist layer 3 is exposed to ultraviolet rays while a mask pattern formed with a desired pattern is placed on the photoresist layer, and developed to form a desired resist pattern 4 (Fig. 1C). Subsequently, the surface on which the resist pattern 4 is formed is subjected to dry etching, and a colored pattern 5 similar to the resist pattern 4 is formed on the colored layer 2 using the resist pattern 4 as an etching mask (Figs. 1D and 1E). After the dry etching, the remaining resist pattern 4 is brought into contact with a stripping liquid to remove the resist pattern 4 from the colored pattern 5, whereby a colored pattern for a solid-state imaging element can be obtained.

The material of the base material 1 may be transparent to visible light. For example, polyester resins such as polyethylene terephthalate and polyethylene naphthalate; acetate resins; polyethersulfone resins; polycarbonate resins; polyamide resins; polyimide resins; polyolefin resins; (meth)acrylic resins; polystyrene resins; polyvinyl alcohol resins; polyarylate resins; polyphenylene sulfide resins; and glass and so on can be enumerated.

A photosensitive resin composition for the photoresist layer 3 is not particularly limited, and can be appropriately selected from well-known photosensitive resin compositions for dry etching applications.

As plasma sources used for dry etching, capacitively coupled plasma (CCP), electron cyclotron resonance plasma (ECR), helicon wave plasma (HWP), inductively coupled plasma (ICP), and surface wave plasma (SWP) and so on can be enumerated. Among these, ICP which has good plasma stability and is suitable for fine processing is particularly preferable.

A gas used for dry etching may be a gas which is reactive (oxidative and reductive), that is, has etching properties. A gas having a halogen element such as fluorine, chlorine, or bromine in its configuration or a gas similarly having elements such as oxygen or sulfur in its configuration and so on can be used. In addition, in a case of etching through ion bombardment, Group 18 elements (noble gases) such as helium or argon may be used. In addition, by mixing a reactive gas with a noble gas, it is possible to etch a material to be etched in a rectangular shape through an ion-assisted reaction. Therefore, it is particularly preferable to perform etching with a mixed gas of a reactive gas and a noble gas.

Either an organic solvent or an inorganic solvent may be used for a stripping liquid, and one which has high peeling properties and does not damage a coloring composition can be selected. For example, a stripping liquid containing at least one selected from the group consisting of N-methylpyrrolidone, dimethyl sulfoxide, and monoethanolamine is suitable.

### [Examples]

Hereinafter, the present invention will be described with reference to examples, but is not limited thereto. In the examples, the units "parts" and "%" respectively represent "parts by mass" and "mass%." In addition, "PGMAC" means methoxypropyl acetate.

In addition, a method for measuring a weight-average molecular weight (Mw) of a resin is as follows.

### (Weight-Average Molecular Weight (Mw) of Resin)

The weight-average molecular weight (Mw) of a resin is a weight-average molecular weight (Mw) in terms of polystyrene measured through GPC (manufactured by TOSOH CORPORATION, HLC-8120GPC) equipped with an RI detector using THF as a development solvent using a TSKgel column (manufactured by TOSOH CORPORATION).

Subsequently, a production method for a binder resin solution, a production method for a refined pigment, and a production method for a pigment dispersion used in the examples and comparative examples will be described.

### <Production Method for Binder Resin Solution>

### (Acrylic Resin Solution 1)

196 Parts of cyclohexanone was added to a reaction container in which a separable four-neck flask was equipped with a thermometer, a cooling tube, a nitrogen gas introduction tube, a dropping tube, and a stirrer, the temperature was raised to 80°C, and the air in the reaction container was replaced with nitrogen. Thereafter, a mixture of 24.0 parts of benzyl methacrylate, 20.2 parts of n-butyl methacrylate, 14.9 parts of 2-hydroxyethyl methacrylate, 24.7 parts of paracumylphenol ethylene oxide-modified acrylate ("ARONIX M110" manufactured by TOAGOSEI CO., LTD.), and 1.1 parts of 2,2'-azobisisobutyronitrile was added dropwise thereto for 2 hours using the dropping tube. After the completion of the dropwise addition, the reaction was continued for another 3 hours to obtain an acrylic resin solution.

After the resultant was cooled to room temperature, about 2 parts of the resin solution was sampled and heat-dried for 20 minutes at 180°C, and a nonvolatile content was measured. PGMAC was added to the previously synthesized resin solution so that the nonvolatile content became 20 weight% to prepare an acrylic resin solution 1. The weight-average molecular weight (Mw) was 26,000.

### <Production Method for Dispersant>

### [Production Method for Dispersant (b1) Having Acidic Functional Group]

### (Dispersant (b1-1) Having Acidic Functional Group)

70.0 parts of methyl methacrylate, 10.0 parts of ethyl acrylate, and 20.0 parts of t-butyl methacrylate were added to a reaction container equipped with a gas introduction tube, a thermometer, a condenser, and a stirrer, and the air was replaced with a nitrogen gas. The reaction container was heated to 80°C, and a solution obtained by dissolving 0.1 parts of 2,2'-azobisisobutyronitrile in 45.3 parts of PGMAC was added to 6.0 parts of 3-mercapto-1,2-propanediol to cause a reaction for 10 hours. It was confirmed through solid content measurement that 95% of the mixture had reacted. At this time, the weight-average molecular weight was 4,000. Next, 9.7 parts of pyromellitic acid dianhydride (manufactured by Daicel Corporation), 70.1 parts of PGMAC, and 0.2 parts of 1,8-diazabicyclo-[5.4.0]-7-undecene were added thereto as catalysts to cause a reaction for 7 hours at 120°C. It was confirmed that at least 98% of acid anhydride was half-esterified in measurement of an acid value, and the reaction was completed. After the completion of the reaction, PGMAC was added thereto so that the nonvolatile content became 50 weight% to obtain a solution of a dispersant (b1-1) having an acid value of 43 mgKOH/g, a weight-average molecular weight of 9,500, and an acidic functional group.

### (Dispersants (b1-2) to (b1-5) Having Acidic Functional Group)

PGMAC solutions of dispersants (b1-2) to (b1-5) having an acidic functional group were obtained by performing synthesis similarly to the dispersant (b1-1) except that the components and the amount added were changed to those shown in Table 3.

A list of the compositions of the obtained dispersants (b1-1) to (b1-5) and a list of theoretical values of glass transition temperatures (Tg) of the region (b1-A) formed by polymerizing an ethylenically unsaturated monomer containing a (meth)acrylate are shown in Table 3. Here, a FOX equation was used to obtain the theoretical values of the glass transition temperatures.

**[Table 3]**

| Table 3 | Dispersant (b1) having acidic functional group | b1-1 | b1-2 | b1-3 | b1-4 | b1-5 |
|---|---|---|---|---|---|---|
| First stage (parts by mass) | MAA | | | 5.0 | 5.0 | |
| | MMA | 70.0 | 70.0 | 55.0 | 55.0 | 55.0 |
| | EA | 10.0 | 10.0 | 40.0 | 40.0 | 45.0 |
| (b1-A) region | t-BMA | 20.0 | 20.0 | | | |
| | Thioglycerol | 6.0 | 3.0 | 6.0 | 6.0 | 6.0 |
| | AIBN | 0.1 | 0.1 | 0.1 | 0.1 | 0.1 |
| | PGMAC | 45.3 | 45.3 | 45.3 | 45.3 | 45.3 |
| | Glass transition temperature of region (b1-A) | 87°C | 87°C | 42°C | 42°C | 35°C |
| Second stage (parts by mass) | PMA | 9.7 | | | 9.7 | 9.7 |
| | TMA | | 21.3 | 21.3 | | |
| | DBU | 0.2 | 0.2 | 0.2 | 0.2 | 0.2 |
| | PGMAC | 70.1 | 70.1 | 70.1 | 70.1 | 70.1 |
| Acid value (mgKOH/g) | | 43 | 32 | 62 | 74 | 43 |
| Weight-average molecular weight | | 9,500 | 9,000 | 9,000 | 9,500 | 9,500 |

Each component in Table 3 is as follows.
<Ethylenically Unsaturated Monomer>
   · MAA: Methacrylic acid
   · MMA: Methyl methacrylate
   · EA: Ethyl acrylate
   · t-BMA: tert-Butyl acrylate
<Compound Having One Thiol Group and Two Hydroxyl Groups in Its Molecule>
   · Thioglycerol: 3-Mercapto-1,2-propanediol
<Radical Polymerization Initiator>
   · AIBN: 2,2'-Azobisisobutyronitrile
<Organic Solvent>
   · PGMAC
<Tetracarboxylic Acid Dianhydride>
   · PMA: Pyromellitic acid dianhydride (manufactured by Daicel Corporation)
   · TMA: Trimellitic anhydride
<Esterification Reaction Catalyst>
   · DBU: 1,8-Diazabicyclo-[5.4.0]-7-undecene (manufactured by San-Apro Ltd.)

### [Production Method for Dispersant (b2) Having Basic Functional Group]

### (Dispersant (b2-1) Having Basic Functional Group)

60 Parts of methyl methacrylate, 20 parts of n-butyl methacrylate, and 13.2 parts of tetramethylethylenediamine (hereinafter, referred to as TMEDA) were added to a reactor equipped with a gas introduction tube, a condenser, a stirring blade, and a thermometer, and the mixture was stirred for 1 hour at 50°C while passing nitrogen to replace the air in the system with nitrogen. Next, 9.3 parts of ethyl bromoisobutyrate, 5.6 parts of cuprous chloride, and 133 parts of PGMAC were added thereto, and the temperature thereof was raised to 110°C to start polymerization of a first block in a nitrogen stream. After the polymerization for 4 hours, solid content measurement was performed by sampling the polymerization solution, and it was confirmed that a polymerization conversion rate was at least 98% in terms of a nonvolatile content.

Next, 61 parts of PGMAC and 20 parts of dimethylaminoethyl methacrylate (hereinafter, referred to as DM) as a second block monomer were added to this reactor, and the mixture was stirred while maintaining a nitrogen atmosphere at 110°C to continue the reaction. Two hours after the addition of dimethylaminoethyl methacrylate, the polymerization solution was sampled to measure the nonvolatile content. It was confirmed that the polymerization conversion rate of a second block in terms of a nonvolatile content was at least 98%, and the reaction solution was cooled to room temperature to stop the polymerization.

PGMAC was added to the previously synthesized block copolymer solution so that the nonvolatile content became 50 mass%. In this manner, a dispersant (b2-1) which had a basic functional group, a tertiary amino group, and a poly(meth)acrylate skeleton having an amine value per nonvolatile content of 71.4 mgKOH/g, a weight-average molecular weight of 9,900 (Mw), and 50 mass% of a nonvolatile content was obtained.

### (Dispersants (b2-2) to (b2-5) Having Basic Functional Group)

PGMAC solutions of dispersants (b2-2) to (b2-5) having a basic functional group were obtained by performing synthesis similarly to the dispersant (b2-1) except that the components and the amount added were changed to those shown in Table 4.

**[Table 4]**

| Table 4 | | b2-1 | b2-2 | b2-3 | b2-4 | b2-5 |
|---|---|---|---|---|---|---|
| First block (parts by mass) | MMA | 60.0 parts | 80.0 parts | | 50.0 parts | 60.0 parts |
| | n-BMA | 20.0 parts | | 80.0 parts | | |
| | EA | | | | 20.0 parts | |
| | t-BMA | | | | | 20.0 parts |
| | TMEDA | 13.2 parts | 13.2 parts | 13.2 parts | 13.2 parts | 13.2 parts |
| | Ethyl bromoisobutyrate | 9.3 parts | 9.3 parts | 9.3 parts | 9.3 parts | 9.3 parts |
| | Cuprous chloride | 5.6 parts | 5.6 parts | 5.6 parts | 5.6 parts | 5.6 parts |
| | PGMAC | 133 parts | 133 parts | 133 parts | 133 parts | 133 parts |
| Second block (parts by mass) | PGMAC | 61.0 parts | 61.0 parts | 61.0 parts | 61.0 parts | 61.0 parts |
| | DM | 20.0 parts | 20.0 parts | 20.0 parts | 20.0 parts | 20.0 parts |
| Amine value (mgKOH/g) | | 71.4 | 71.4 | 71.4 | 71.4 | 71.4 |
| Weight-average molecular weight | | 9,900 | 9,900 | 9,900 | 9,900 | 9,900 |

Each component in Table 4 is as follows.
- MMA: Methyl methacrylate
- n-BMA: n-butyl methacrylate
- TMEDA: Tetramethylethylenediamine
- DM: Dimethylaminoethyl methacrylate

### <Production of Yellow Fine Pigment (Y1)>

100 parts of an isoindolinone yellow pigment C.I. Pigment Yellow 139 (PY139, "PALIOTOL YELLOW D1819" manufactured by BASF SE), 800 parts of pulverized table salt, and 180 parts of diethylene glycol were added to a stainless steel 1-gallon kneader (manufactured by INOUE MFG., INC.), and the mixture was kneaded for 4 hours at 70°C. This mixture was added to 3,000 parts of warm water and stirred with a high speed mixer for about 1 hour while heating at about 80°C to form a slurry. The slurry was repeatedly filtered and washed with water to remove table salt and the solvent, and was then dried for 24 hours at 80°C to obtain 96 parts of a yellow fine pigment (Y1).

### <Production of Yellow Fine Pigment (Y2)>

95 Parts of C.I. Pigment Yellow 185 ("Paliogen Yellow D1155" manufactured by BASF SE), 3.5 parts of a coloring matter derivative, 10 parts of rosin-maleic acid resin ("MALKYD 32" manufactured by Arakawa Chemical Industries, Ltd.), 1,200 parts of sodium chloride, and 120 parts of diethylene glycol were added to a stainless steel 1-gallon kneader (manufactured by INOUE MFG., INC.), and the mixture was kneaded for 8 hours at 60°C. Next, this kneaded material was added to 8,000 parts of warm water and stirred for 1 hour while heating at about 70°C to form a slurry. The slurry was repeatedly filtered and washed with water to remove sodium chloride and diethylene glycol, and was then dried for a day and night at 80°C to obtain 105 parts of a yellow fine pigment (Y2).

### <Production Method for Pigment Dispersion>

### (Green Pigment Dispersion (GP-1))

The following mixture was stirred and mixed so as to be uniform, and was then dispersed using a paint shaker SO400 (manufactured by Skandex) for 5 hours with zirconia beads having a diameter of 1 mm. Thereafter, 30.0 parts of PGMAC was added thereto and then filtered through a 5 µm filter to obtain a green pigment dispersion (GP-1).
C.I. Pigment Green 58: 6.7 parts ("FASTOGEN GREEN A110" manufactured by DIC CORPORATION)
C.I. Pigment Yellow 150: 6.7 parts ("E4GN" manufactured by LANXESS")
Pigment derivative which is compound represented by Formula (7) below: 1.6 parts
Dispersant solution (b1-1) having acidic functional group: 5.0 parts
Dispersant solution (b2-1) having basic functional group: 5.0 parts
PGMAC: 75.0 parts

### (Green Pigment Dispersions (GP-2 to GP-19))

Green pigment dispersions (GP-2 to GP-19) were obtained similarly to the green pigment dispersion (GP-1) except that the components and the formulation amounts (parts by mass) were changed as those shown in Table 5.

**[Table 5]**

| Table 5 | Pigment | | | | | | | Coloring matter derivative | | Dispersant solution (b1) having acidic functional group | | Dispersant solution (b2) having basic functional group | | Acrylic resin solution 1 | Methoxypropyl acetate |
|---|---|---|---|---|---|---|---|---|---|---|---|---|---|---|---|
| | PG58-1 | PG58-2 | PG36 | PG7 | PY150 | PY139 | PY185 | | | | | | | | |
| GP-1 | 6.7 parts | | | 6.7 | 6.7 parts | | | Formula (7) | 1.6 parts | b1-1 | 5.0 parts | b2-1 | 5.0 parts | | 75.0 parts |
| GP-2 | 6.7 parts | | | 6.7 | 6.7 parts | | | Formula (8) | 1.6 parts | b1-1 | 5.0 parts | b2-1 | 5.0 parts | | 75.0 parts |
| GP-3 | 6.7 parts | | | 6.7 | 6.7 parts | | | Formula (7) | 1.6 parts | b1-2 | 5.0 parts | b2-1 | 5.0 parts | | 75.0 parts |
| GP-4 | 6.7 parts | | | 6.7 | 6.7 parts | | | Formula (7) | 1.6 parts | b1-3 | 5.0 parts | b2-1 | 5.0 parts | | 75.0 parts |
| GP-5 | 6.7 parts | | | 6.7 | 6.7 parts | | | Formula (7) | 1.6 parts | b1-4 | 5.0 parts | b2-1 | 5.0 parts | | 75.0 parts |
| GP-6 | 6.7 parts | | | 6.7 | 6.7 parts | | | Formula (7) | 1.6 parts | b1-5 | 5.0 parts | b2-1 | 5.0 parts | | 75.0 parts |
| GP-7 | 6.7 parts | | | 6.7 | 6.7 parts | | | Formula (7) | 1.6 parts | | | b2-1 | 10.0 parts | | 75.0 parts |
| GP-8 | | 6.7 parts | | 6.7 | 6.7 parts | | | Formula (7) | 1.6 parts | b1-1 | 5.0 parts | b2-1 | 5.0 parts | | 75.0 parts |
| GP-9 | 6.7 parts | | | 6.7 | 6.7 parts | | | Formula (7) | 1.6 parts | b1-2 | 5.0 parts | b2-2 | 5.0 parts | | 75.0 parts |
| GP-10 | 6.7 parts | | | 6.7 | 6.7 parts | | | Formula (7) | 1.6 parts | b1-2 | 5.0 parts | b2-3 | 5.0 parts | | 75.0 parts |
| GP-11 | 6.7 parts | | | 6.7 | 6.7 parts | | | Formula (7) | 1.6 parts | b1-2 | 5.0 parts | b2-4 | 5.0 parts | | 75.0 parts |
| GP-12 | 6.7 parts | | | 6.7 | 6.7 parts | | | Formula (7) | 1.6 parts | b1-2 | 5.0 parts | b2-5 | 5.0 parts | | 75.0 parts |
| GP-13 | 9.7 parts | | | 3.7 | 3.7 parts | | | Formula (7) | 1.6 parts | b1-2 | 5.0 parts | b2-1 | 5.0 parts | | 75.0 parts |
| GP-14 | | | 6.7 parts | | 6.7 parts | | | Formula (7) | 1.6 parts | b1-1 | 5.0 parts | b2-1 | 5.0 parts | | 75.0 parts |
| GP-15 | | | 6.7 parts | | 6.7 parts | | | Formula (7) | 1.6 parts | b1-1 | 10.0 parts | | | | 75.0 parts |
| GP-16 | 8.2 parts | | | 1.5 parts | 3.7 parts | | | Formula (7) | 1.6 parts | b1-2 | 5.0 parts | b2-1 | 5.0 parts | | 75.0 parts |
| GP-17 | 8.2 parts | | | | 2.6 parts | 2.6 parts | | Formula (8) | 1.6 parts | b1-2 | 5.0 parts | b2-1 | 5.0 parts | | 75.0 parts |
| GP-18 | 8.0 parts | | | | | | 5.4 parts | Formula (7) | 1.6 parts | b1-2 | 5.0 parts | b2-1 | 5.0 parts | | 75.0 parts |
| GP-19 | 6.7 parts | | | | 6.7 parts | | | Formula (7) | 1.6 parts | b1-1 | 4.0 parts | b2-1 | 4.0 parts | 5.0 parts | 72.0 parts |
| GP-20 | 6.7 parts | | | | 6.7 parts | | | Formula (7) | 1.6 parts | | | | | 25.0 parts | 50.0 parts |

Each component in Table 5 is as follows.
<Pigment>
   · PG58-1: C.I. Pigment Green 58 ("FASTOGEN GREEN A110" manufactured by DIC CORPORATION)
   · PG58-2: C.I. Pigment Green 58 ("FASTOGEN GREEN A210" manufactured by DIC CORPORATION)
   · PG36: C.I. Pigment Green 36 ("CF-G-6YK" manufactured by TOYOCOLOR CO., LTD.)
   · PG7: C.I. Pigment Green 7 ("Fastogen Green S" manufactured by DIC CORPORATION)
   · PY150: C.I. Pigment Yellow 150 ("E4GN" manufactured by LANXESS")
   · PY139: C.I. Pigment Yellow 138 (yellow fine pigment (Y1))
   · PY185: C.I. Pigment Yellow 185 (yellow fine pigment (Y2))
<Coloring Matter Derivative>

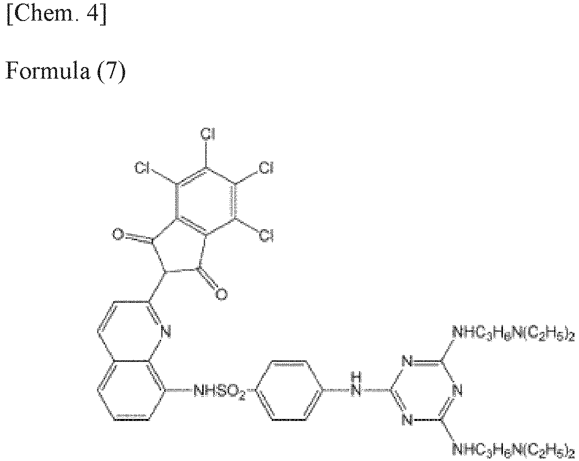

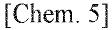

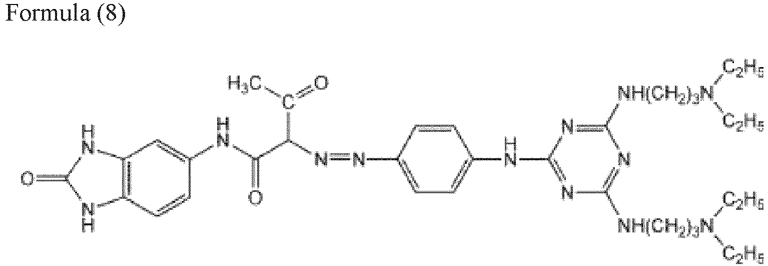

### <Production Method for Thermosetting Coloring Composition>

### [Example 1]

### (Preparation of Thermosetting Coloring Composition (GT-1))

The following mixture (100 parts in total) was stirred and mixed so as to be uniform and filtered through a 1.0 µm filter to obtain a thermosetting coloring composition (GT-1).
Pigment dispersion (GP-1): 77.2 parts
Thermosetting compound C: 1.6 parts
   "Denacol EX-313" manufactured by Nagase ChemteX Corporation
Leveling agent solution: 1.0 part
   "FZ-2122" manufactured by Dow Corning Toray Co., Ltd.
   (Solution obtained by diluting 1 part thereof (100 mass% of nonvolatile content) in 99 parts of cyclohexanone)
Solvent (D): 10.2 parts
   PGMAC
Solvent (d1): 10.0 parts
   Cyclohexanol acetate

### [Example 2 to 19 and Comparative Examples 1 to 7]

### (Preparation of Thermosetting Coloring Compositions (GT-2 to GT-26))

Thermosetting coloring compositions (GT-2 to GT-26) were obtained similarly to the thermosetting coloring composition (GT-1) except that the components and the formulation amounts (parts by mass) were changed as those shown in Table 6-9.

### <Evaluation of Thermosetting Coloring Composition>

The obtained thermosetting coloring compositions were evaluated for viscosity stability, a stripping liquid resistance, and a foreign substance in a coating film. The results are shown in Tables 6 to 9.

### <Viscosity Stability Evaluation>

The viscosity of the thermosetting coloring compositions immediately after preparation at 25°C and the viscosity of the thermosetting coloring compositions after storage in a constant temperature chamber at 13°C for 6 months were measured using an E-type viscometer (TUE-20L type manufactured by TOKI SANKGYO CO., LTD.) at a rotation frequency of 20 rpm. The viscosity of the coloring compositions on the day of preparation was defined as an initial viscosity (η0: mPa·s), and the viscosity of the coloring compositions after storage in a constant temperature chamber at 13°C for 1 month was defined as a viscosity (η1: mPa s) to evaluate the dispersion stability based on the following criteria, × is a non-practical level.
⊙: η1/η0 is at most 1.10
O: η1/η0 is greater than 1.10 and smaller than 1.20
×: η1/η0 is at least 1.20

### <Stripping Liquid Resistance Evaluation 1>

Three glass substrates with 100 mm × 100 mm and a thickness of 1.1 mm were coated with a thermosetting coloring composition obtained so as to have a dry coating film of 0.7 µm using each spin coater and were heated and calcined in an oven for 30 minutes at 230°C. The obtained three coated substrates were immersed in a stripping liquid (a 4:6 mixed solution of N-methylpyrrolidone: dimethyl sulfoxide) for 1 minute, 3 minutes, or 5 minutes, and were then observed with an optical microscope to perform an evaluation. The evaluation ranks are as follows. × is a non-practical level.
⊙: All substrates immersed for 1 minute, 3 minutes, and 5 minutes have a favorable appearance without any change.
O: There is no change in appearance in the substrates immersed for 1 minute and 3 minutes, but any of cracks, surface roughness, and foreign substances is generated in the substrate immersed for 5 minutes.
Δ: There is no change in appearance in the substrate immersed for 1 minute, but any of cracks, surface roughness, and foreign substances is generated in the substrate immersed for 3 minutes.
×: Any of cracks, surface roughness, and foreign substances is generated in the substrate immersed for 1 minute.

### <Stripping Liquid Resistance Evaluation 2>

Three glass substrates with 100 mm × 100 mm and a thickness of 1.1 mm were coated with a thermosetting coloring composition obtained so as to have a dry coating film of 0.7 µm using each spin coater and were heated and calcined in an oven for 30 minutes at 230°C. The obtained three coated substrates were immersed in a stripping liquid (a 5:5 mixed solution of dimethyl sulfoxide: monoethanolamine) for 1 minute, 3 minutes, or 5 minutes, and were then observed with an optical microscope to perform an evaluation. The evaluation ranks are as follows. × is a non-practical level.
⊙: All substrates immersed for 1 minute, 3 minutes, and 5 minutes have a favorable appearance without any change.
O: There is no change in appearance in the substrates immersed for 1 minute and 3 minutes, but any of cracks, surface roughness, and foreign substances is generated in the substrate immersed for 5 minutes.
Δ: There is no change in appearance in the substrate immersed for 1 minute, but any of cracks, surface roughness, and foreign substances is generated in the substrate immersed for 3 minutes.
×: Any of cracks, surface roughness, and foreign substances is generated in the substrate immersed for 1 minute.

### <Evaluation of Foreign Substance in Coating Film>

A glass substrate with 100 mm × 100 mm and a thickness of 1.1 mm was coated with each thermosetting coloring composition, which had been stored in a refrigerator for 1 month at 10°C and was obtained so as to have a dry coating film of 0.7 µm, using each spin coater, and was dried with a hot plate for 1 minute at 70°C. The substrate with the obtained dry coating film was visually observed to evaluate foreign substances. × is a non-practical level.
⊙: There is no foreign substance on the substrate.
O: At least one and less than three foreign substances are on the substrate.
Δ: At least three and less than five foreign substances are on the substrate.
×: At least five foreign substances are on the substrate.

### <Evaluation of Appropriateness of Dry Etching Process>

Silicon wafer substrates were coated with a thermosetting coloring composition obtained so as to have a dry coating film of 0.7 µm, using each spin coater. Subsequently, baking was performed for 6 minutes at 230°C to cure the thermosetting coloring composition (green color filter film).

Next, a positive type resist (OFPR-800: manufactured by TOKYO OHKA KOGYO CO., LTD.) was spin-coated at a rotation frequency of 1,000 rpm using a spin coater, and then pre-baked for 1 minute at 90°C. Accordingly, samples coated with the photoresist which was a photosensitive resin mask material layer at a film thickness of 1.5 µm were prepared.

The above-described positive type resist which is the photosensitive resin mask material layer underwent a chemical reaction through ultraviolet irradiation and dissolved in a developing solution.

The above-described samples were subjected to photolithography in which the samples were exposed through a photo mask. An exposure device in which an i-line wavelength was used as a light source was used. The positive type resist underwent a chemical reaction through ultraviolet irradiation and dissolved in a developing solution.

Next, a developing step was performed using 2.38 weight% tetramethylammonium hydride (TMAH) as a developing solution to form an etching mask having an opening portion of 0.8 µm. When using the positive type resist, in many cases, the positive type resist is dehydration-baked after development to be cured. However, no baking process was performed this time to facilitate removal of the etching mask after dry etching. For this reason, no improvement in selection ratio was expected due to no curing of the resist. Therefore, the resist was formed to have a film thickness of 1.5 µm which was twice or more of the thickness of the green color filter film. The pattern of the opening portion formed at this time was 0.8 µm × 0.8 µm. Accordingly, an etching mask pattern using the positive type resist was formed.

Next, dry etching of the green filter layer was performed using the formed etching mask pattern. At this time, a dry etching device used was an ICP type dry etching device. In addition, in order to make the cross-sectional shape vertical, the dry etching conditions were changed in the middle of the process, and the dry etching was carried out in multiple stages.

Next, the positive type resist used as the etching mask was removed. A solvent was used in the method used at this time, and the positive type resist was removed using a spray-washing device with Stripping Liquid 104 (manufactured by TOKYO OHKA KOGYO CO., LTD.)

Color filters having patterns having thicknesses of 0.5 µm and 0.8 µm were obtained through dry etching based on the above-described production method. The obtained color filters were observed with an SEM and evaluated. The evaluation ranks are as follows. × is a non-practical level.
⊙: No foreign substance is found.
O: There is a foreign substance, but it is at a practical level.
×: There is a foreign substance.

**[Table 6]**

| Table 6 | | Example 1 | Example 2 | Example 3 | Example 4 | Example 5 | Example 6 | Example 7 |
|---|---|---|---|---|---|---|---|---|
| | | GT-1 | GT-2 | GT-3 | GT-4 | GT-5 | GT-6 | GT-7 |
| Pigment dispersion | | GP-1 | GP-2 | GP-3 | GP-4 | GP-5 | GP-6 | GP-7 |
| | | 77.2 parts | 77.2 parts | 77.2 parts | 77.2 parts | 77.2 parts | 77.2 parts | 77.2 parts |
| Thermosetting compound C | | EX-313 | EX-313 | EX-313 | EX-313 | EX-313 | EX-313 | EX-313 |
| | | 1.6 parts | 1.6 parts | 1.6 parts | 1.6 parts | 1.6 parts | 1.6 parts | 1.6 parts |
| Acrylic resin solution | | | | | | | | |
| Leveling agent solution | | 1.0 parts | 1.0 parts | 1.0 parts | 1.0 parts | 1.0 parts | 1.0 parts | 1.0 parts |
| Solvent D | | | | | | | | |
| | PGMAC | 102 parts | 10.2 parts | 10.2 parts | 102 parts | 102 parts | 10.2 parts | 10.2 parts |
| | Cyclohexanol acetate | 10.0 parts | 10.0 parts | 10.0 parts | 10.0 parts | 10.0 parts | 10.0 parts | 10.0 parts |
| Proportion of organic pigment (A) in total solid content of thermosetting coloring composition | | 60.7% | 60.7% | 60.7% | 60.7% | 60.7% | 60.7% | 60.7% |
| Proportion of thermosetting compound (C) in total solid content of thermosetting coloring composition | | 9.4% | 9.4% | 9.4% | 9.4% | 9.4% | 9.4% | 9.4% |

| Evaluation | | Example 1 | Example 2 | Example 3 | Example 4 | Example 5 | Example 6 | Example 7 |
|---|---|---|---|---|---|---|---|---|
| <Viscosity stability evaluation> | | ⊙ | ⊙ | ⊙ | ⊙ | ⊙ | ⊙ | ○ |
| <Stripping liquid resistance evaluation 1> | | ⊙ | ⊙ | ⊙ | ○ | ○ | Δ | Δ |
| <Stripping liquid resistance evaluation 2> | | ⊙ | ⊙ | ⊙ | ○ | ○ | Δ | Δ |
| <Evaluation of foreign substance in coating film> | | ⊙ | ⊙ | ⊙ | ⊙ | ⊙ | ⊙ | ⊙ |
| <Evaluation of appropriateness of dry etching process> | | ⊙ | ⊙ | ⊙ | ○ | ○ | ○ | ○ |

**[Table 7]**

| Table 7 | | Example 8 | Example 9 | Example 10 | Example 11 | Example 12 | Example 13 | Example 14 |
|---|---|---|---|---|---|---|---|---|
| | | GT-8 | 3T-9 | GT-10 | GT-11 | GT-12 | GT-13 | GT-14 |
| Pigment dispersion | | GP-8 | GP-9 | GP-10 | GP-11 | GP-12 | GP-13 | GP-14 |
| | | 772 parts | 77.2 parts | 77.2 parts | 77.2 parts | 77.2 parts | 77.2 parts | 77.2 parts |
| Thermosetting compound C | | EX-313 | EX-313 | EX-313 | EX-313 | EX-313 | EX-313 | EX-313 |
| | | 1.6 parts | 1.6 parts | 1.6 parts | 1.6 parts | 1.6 parts | 1.6 parts | 1.6 parts |
| Acrylic resin solution | | | | | | | | |
| Leveling agent solution | | 1.0 parts | 1.0 parts | 1.0 parts | 1.0 parts | 1.0 parts | 1.0 parts | 1.0 parts |
| Solvent D | | | | | | | | |
| | PGMAC | 102 parts | 102 parts | 10.2 parts | 10.2 parts | 102 parts | 10.2 parts | 102 parts |
| | Cyclohexanol acetate | 100 parts | 100 parts | 10.0 parts | 10.0 parts | 10.0 parts | 10.0 parts | 100 parts |
| Proportion of organic pigment (A) in total solid content of thermosetting coloring composition | | 50.7% | 60.7% | 60.7% | 60.7% | 60.7% | 60.7% | 60.7% |
| Proportion of thermosetting compound (C) in total solid content of thermosetting coloring composition | | 9.4% | 9.4% | 9.4% | 9.4% | 9.4% | 9.4% | 9.4% |

| Evaluation | | Example 8 | Example 9 | Example 10 | Example 11 | Example 12 | Example 13 | Example 14 |
|---|---|---|---|---|---|---|---|---|
| <Viscosity stability evaluation> | | ⊙ | ⊙ | ⊙ | ⊙ | ⊙ | ⊙ | ⊙ |
| <Stripping liquid resistance evaluation 1> | | ⊙ | ⊙ | ⊙ | ⊙ | ⊙ | ⊙ | ⊙ |
| <Stripping liquid resistance evaluation 2> | | ⊙ | ⊙ | ⊙ | ⊙ | ⊙ | ⊙ | ⊙ |
| <Evaluation of foreign substance in coating film> | | ⊙ | ⊙ | ⊙ | ⊙ | ⊙ | ⊙ | ⊙ |
| <Evaluation of appropriateness of dry etching process> | | ⊙ | ⊙ | ⊙ | ⊙ | ⊙ | ⊙ | ⊙ |

**[Table 8]**

| Table 8 | | Example 15 | Example 16 | Example 17 | Example 18 | Example 19 | Example 20 | Example 21 | Example 22 |
|---|---|---|---|---|---|---|---|---|---|
| | | GT-15 | GT-16 | GT-17 | GT-18 | GT-19 | GT-20 | GT-21 | GT-22 |
| Pigment dispersion | | GP-15 | GP-16 | GP-17 | GP-18 | GP-19 | GP-4 | GP-4 | GP-4 |
| | | 77.2 parts | 77.2 parts | 77.2 parts | 77.2 parts | 77.2 parts | 77.2 parts | 77.2 parts | 77.2 parts |
| Thermosetting compound C | | EX-313 | EX-313 | EX-313 | EX-313 | EX-313 | EX-314 | EX-252 | ER828 |
| | | 1.6 parts | 1.6 parts | 1.6 parts | 1.6 parts | 1.6 parts | 1.6 parts | 1.6 parts | 1.6 parts |
| Acrylic resin solution | | | | | | | | | |
| Leveling agent solution | | 1.0 parts | 1.0 parts | 1.0 parts | 1.0 parts | 1.0 parts | 1.0 parts | 1.0 parts | 1.0 parts |
| Solvent D | | | | | | | | | |
| | PGMAC | 102 parts | 102 parts | 102 parts | 10.2 parts | 10.2 parts | 10.2 parts | 10.2 parts | 10.2 parts |
| | Cyclohexanol acetate | 10.0 parts | 10.0 parts | 10.0 parts | 10.0 parts | 10.0 parts | 10.0 parts | 10.0 parts | 10.0 parts |
| Proportion of organic pigment (A) in total solid content of thermosetting coloring composition | | 60.7% | 60.7% | 60.7% | 60.7% | 60.7% | 60.7% | 60.7% | 60.7% |
| Proportion of thermosetting compound (C) in total solid content of thermosetting coloring composition | | 9.4% | 9.4% | 9.4% | 9.4% | 9.4% | 9.4% | 9.4% | 9.4% |
| Evaluation | | Example 15 | Example 16 | Example 17 | Example 18 | example 18 | Example 20 | Example 21 | Example 22 |
| <Viscosity stability evaluation> | | ○ | ⊙ | ⊙ | ⊙ | ○ | ⊙ | ⊙ | ⊙ |
| <Stripping liquid resistance evaluation 1> | | ⊙ | ⊙ | ⊙ | ⊙ | ⊙ | ⊙ | ⊙ | ⊙ |
| <Stripping liquid resistance evaluation 2> | | ⊙ | ⊙ | ⊙ | ⊙ | ⊙ | ⊙ | ⊙ | ⊙ |
| <Evaluation of foreign substance in coating film> | | ⊙ | ⊙ | ⊙ | ⊙ | ⊙ | ⊙ | ⊙ | ⊙ |
| <Evaluation of appropriateness of dry etching process> | | ⊙ | ⊙ | ⊙ | ⊙ | ⊙ | ⊙ | ⊙ | ⊙ |

**[Table 9]**

| Table 9 | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|
| | | GT-23 | GT-24 | GT-25 | GT-26 | GT-27 | GT-28 | GT-29 |
| Pigment dispersion | | GP-20 | GP-4 | GP-4 | GP-4 | GP-4 | GP-4 | GP-4 |
| | | 77.2 parts | 77.3 parts | 77.4 parts | 77.4 parts | 77.4 parts | 77.4 parts | 85.0 parts |
| Thermosetting compound C | | EX-313 | EX-411 | EX-512 | EHPE3150 | EX-611 | | |
| | | 1.6 parts | 1.6 parts | 1.6 parts | 1.6 parts | 1.6 parts | | |
| Acrylic resin solution | | | | | | | 8.0 parts | |
| Leveling agent solution | | 1.0 parts | 1.0 parts | 1.0 parts | 1.0 parts | 1.0 parts | 1.0 parts | 1.0 parts |
| Solvent D | | | | | | | | |
| | PGMAC | 10.2 parts | 10.2 parts | 10.2 parts | 102 parts | 10.2 parts | 3.8 parts | 1.0 parts |
| | Cyclohexanol acetate | 10.0 parts | 10.0 parts | 10.0 parts | 100 parts | 100 parts | 10.0 parts | 10.0 parts |
| Proportion of organic pigment (A) in total solid content of thermosetting coloring composition | | 60.7% | 60.7% | 60.7% | 60.7% | 60.7% | 60.7% | 57.0% |
| Proportion of thermosetting compound (C) in total solid content of thermosetting coloring composition | | 7.4% | 7.4% | 7.4% | 7.4% | 7.4% | 0.0% | 0.0% |
| Evaluation | | Comparative Example 1 | Comparative Example 2 | Comparative Example 3 | Comparative Example 4 | Comparative Example 5 | Comparative Example 6 | Comparative Example 7 |
| <Viscosity stability evaluation> | | × | ⊙ | ⊙ | ⊙ | ⊙ | ⊙ | ⊙ |
| <Stripping liquid resistance evaluation 1> | | Δ | × | × | × | ⊙ | × | × |
| <Stripping liquid resistance evaluation 2> | | Δ | × | × | × | ⊙ | × | × |
| <Evaluation of foreign substance in coating film> | | ⊙ | ⊙ | × | ⊙ | × | ⊙ | ⊙ |
| <Evaluation of appropriateness of dry etching process> | | × | × | × | × | ⊙ | × | × |

The thermosetting compounds (C) in Tables 6 to 9 are as shown in Table 10 below. EX-313 and EX-314 contain bifunctional glycerol diglycidyl ether represented by Chemical formula (1) and trifunctional glycerol triglycidyl ether represented by Chemical Formula (2).

### [Table 10]

**Table 10**

| | | |
|---|---|---|
| EX-313 | "Denacol EX-313" manufactured by Nagase ChemteX Corporation | Glycidyl-etherified epoxy compound of glycerol |
| EX-314 | "Denacol EX-314" manufactured by Nagase ChemteX Corporation | Glycidyl-etherified epoxy compound of glycerol |
| EX-252 | "Denacol EX-252" manufactured by Nagase ChemteX Corporation | Hydrogenated bisphenol-type polyglycidyl ether |
| jER828 | "jER828" manufactured by Mitsubishi Chemical Corporation | Bisphenol-type polyglycidyl ether |
| EX-411 | "Denacol EX-411" manufactured by Nagase ChemteX Corporation | Glycidyl-etherified epoxy compound of pentaerythritol |
| EX-611 | "Denacol EX-611" manufactured by Nagase ChemteX Corporation | Glycidyl-etherified epoxy compound of sorbitol |
| EX-512 | "Denacol EX-512" manufactured by Nagase ChemteX Corporation | Glycidyl-etherified epoxy compound of polyglycerol |
| EHPE3150 | "EHPE 3150" manufactured by Daicel Corporation | 1,2-epoxy-4-(2-oxiranyl)cyclohexene adduct of 2,2'-bis(hydroxymethyl)-1-butanol |

As shown in Tables 6 to 9, it has become clear that the coloring composition of the present invention has excellent viscosity stability and stripping liquid resistance and generation of foreign substances in a coating film is suppressed.
1 Base material
2 Colored layer
3 Photoresist layer
4 Resist pattern
5 Color pattern

## Claims

1. A coloring composition used for forming a colored pattern of a color filter for a solid-state imaging element, the color composition comprising:
an organic pigment (A);
a dispersant (B);
an epoxy compound (C);
a solvent (D); and
a coloring matter derivative (E),
wherein a content of the organic pigment (A) is at least 50 mass% with respect to a non-volatile content in the coloring composition,
wherein the dispersant (B) contains a dispersant (b1) having an acidic functional group and/or a dispersant (b2) having a basic functional group,
wherein the epoxy compound (C) is at least one compound selected from the group consisting of glycerol polyglycidyl ether, bisphenol-type polyglycidyl ether, and hydrogenated bisphenol-type polyglycidyl ether, wherein the glycerol polyglycidyl ether is at least one selected from a bifunctional glycerol diglycidyl ether represented by Chemical Formula (1) below and a trifunctional glycerol triglycidyl ether represented by Chemical Formula (2), and 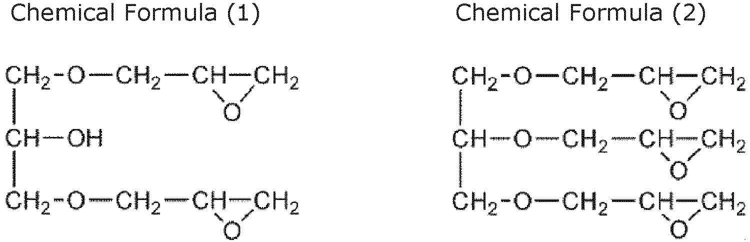
wherein the coloring matter derivative (E) is a compound represented by any one of Formulae (3-1) to (6-5) defined as follows: 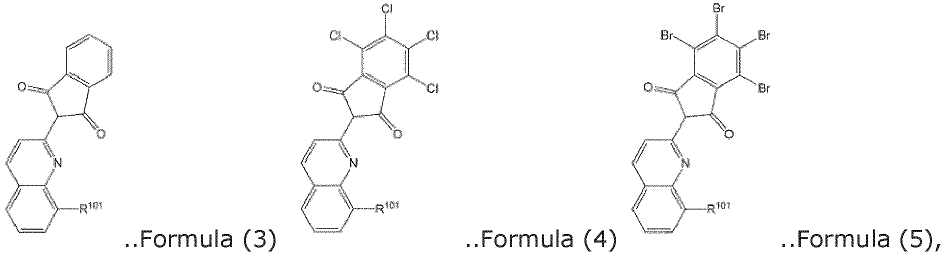 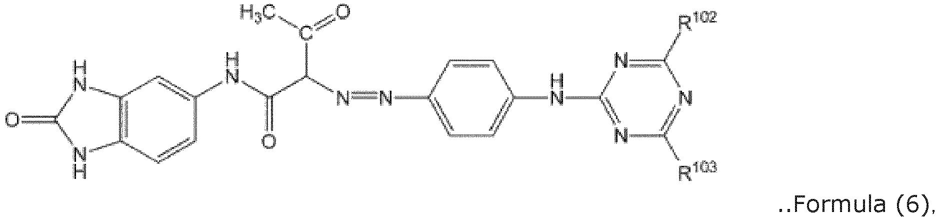 wherein R¹⁰¹ in Formulae (3) to (5) represents a substituent as follows:
in Formula (3-1), (4-1) and (5-1), R¹⁰¹ = 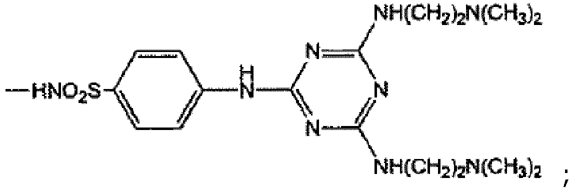
in Formula (3-2), (4-2) and (5-2), R¹⁰¹ = 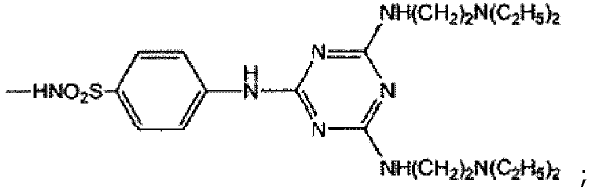
in Formula (3-3), (4-3) and (5-3), R¹⁰¹ = 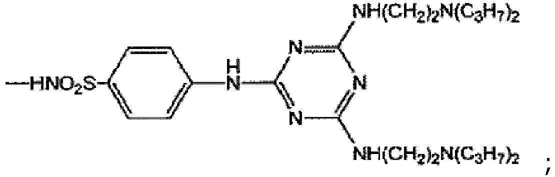
in Formula (3-4), (4-4) and (5-4), R¹⁰¹ = 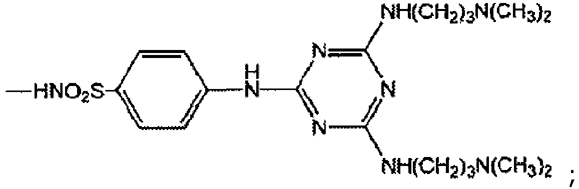
in Formula (3-5), (4-5) and (5-5), R¹⁰¹ = 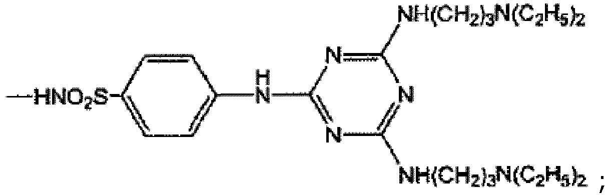
in Formula (3-6), (4-6) and (5-6), R¹⁰¹ = 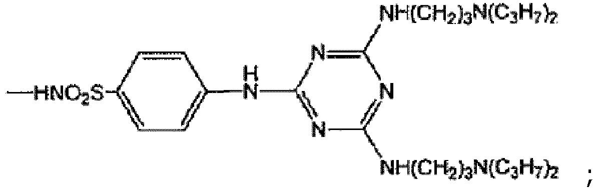
in Formula (3-7), (4-7) and (5-7), R¹⁰¹ = 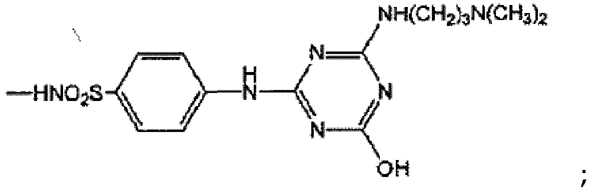
in Formula (3-8), (4-8) and (5-8), R¹⁰¹ = 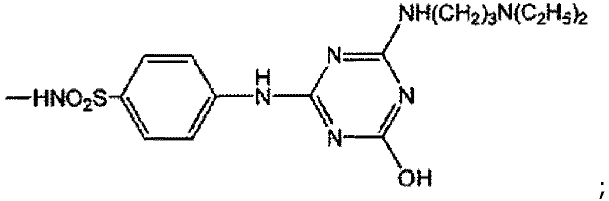
in Formula (3-9), (4-9) and (5-9), R¹⁰¹ = 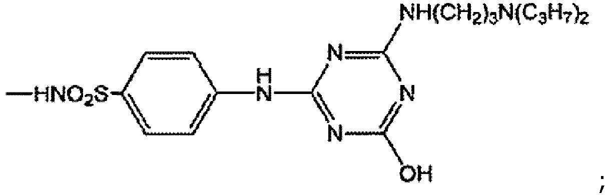
in Formula (3-10), (4-10) and (5-10), R¹⁰¹ = 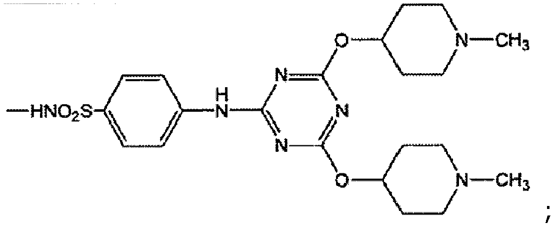 and wherein R¹⁰² and R¹⁰³ in Formula (6) represent substituents as follows:
in Formula (6-1), R¹⁰²= NH(CH₂)₃N(C₂H₅)₂ and R¹⁰³ = OH;
in Formula (6-2), R¹⁰²= NH(CH₂)₃N(C₂H₅)₂ and R¹⁰³ = OCH₃;
in Formula (6-3), R¹⁰²= NH(CH₂)₃N(C₂H₅)₂ and R¹⁰³ = NH(CH₂)₃N(C₂H₅)₂;
in Formula (6-4), R¹⁰²= NH(CH₂)₃N(C₃H₇)₂ and R¹⁰³ = NH(CH₂)₃N(C₃H₇)₂;
in Formula (6-5), R¹⁰²= NH(CH₂)₃N(C₄H₉)₂ and R¹⁰³ = NH(CH₂)₃N(C₄H₉)₂.

2. The coloring composition according to claim 1,
wherein the organic pigment (A) contains a green pigment (a1).

3. The coloring composition according to claim 2,
wherein the green pigment contains at least one selected from Pigment Green 7, Pigment Green 36, and Pigment Green 58.

4. The coloring composition according to any one of claims 1 to 3,
wherein the dispersant (b1) having the acidic functional group has a region (b1-A) formed by polymerizing an ethylenically unsaturated monomer containing a (meth)acrylate, and
wherein a theoretical value of a glass transition temperature of the region (b1-A) is at least 40°C.

5. The coloring composition according to claim 4,
wherein the acidic functional group is an aromatic carboxyl group.

6. A production method for a color filter for a solid-state imaging element, the method comprising:
a step (X) of forming a colored layer using the coloring composition according to any one of claims 1 to 5; and
a step (Y) of patterning the colored layer through dry etching.

7. The production method for a color filter for a solid-state imaging element according to claim 6,
wherein the step (X) includes
a step (X-1) of forming a coating film containing the coloring composition, and
a step (X-2) of obtaining the colored layer by thermosetting the coating film, and
wherein the step (Y) includes
a step (Y-1) of forming a photoresist layer on the colored layer,
a step (Y-2) of obtaining a resist pattern by patterning the photoresist layer through exposure and development,
a step (Y-3) of forming a colored pattern by patterning the colored layer through dry etching using the resist pattern as an etching mask, and
a step (Y-4) of bringing a stripping liquid into contact with the resist pattern to remove the resist pattern from the colored pattern.

8. The production method for a color filter for a solid-state imaging element according to claim 7,
wherein the stripping liquid contains at least one selected from the group consisting of N-methylpyrrolidone, dimethyl sulfoxide, and monoethanolamine.

## Patentansprüche

1. Färbezusammensetzung, die zur Bildung eines gefärbten Musters eines Farbfilters für ein Festkörperabbildungselement verwendet wird, wobei die Färbezusammensetzung umfasst:
ein organisches Pigment (A);
ein Dispersionsmittel (B);
eine Epoxidverbindung (C);
ein Lösungsmittel (D); und
ein Färbemittelderivat (E),
wobei der Gehalt des organischen Pigments (A) mindestens 50 Massen-%, bezogen auf den nichtflüchtigen Gehalt in der Färbezusammensetzung, beträgt,
wobei das Dispersionsmittel (B) ein Dispersionsmittel (b1) mit einer sauren funktionellen Gruppe und/oder ein Dispersionsmittel (b2) mit einer basischen funktionellen Gruppe enthält,
wobei die Epoxyverbindung (C) mindestens eine Verbindung ist, die aus der Gruppe ausgewählt ist, die aus Glycerinpolyglycidylether, Polyglycidylether vom Bisphenoltyp und hydriertem Polyglycidylether vom Bisphenoltyp besteht, wobei der Glycerinpolyglycidylether mindestens einer ist, der aus einem bifunktionellen Glycerindiglycidylether, der durch die nachstehende chemische Formel (1) dargestellt wird, und einem trifunktionellen Glycerintriglycidylether, der durch die chemische Formel (2) dargestellt wird, ausgewählt ist, und 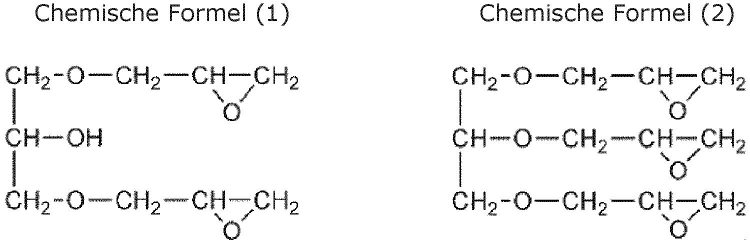
wobei das Färbemittelderivat (E) eine Verbindung ist, die durch eine der Formeln (3-1) bis (6-5), die wie folgt definiert sind, dargestellt wird: 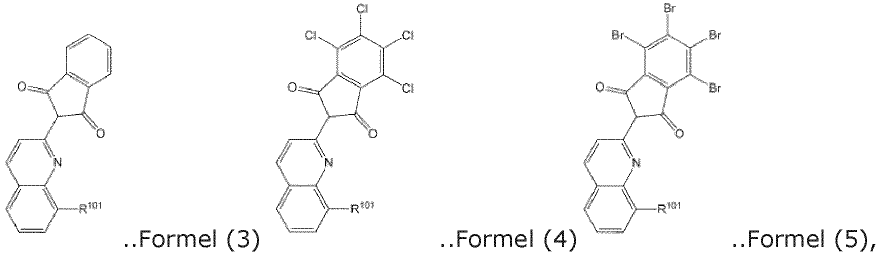 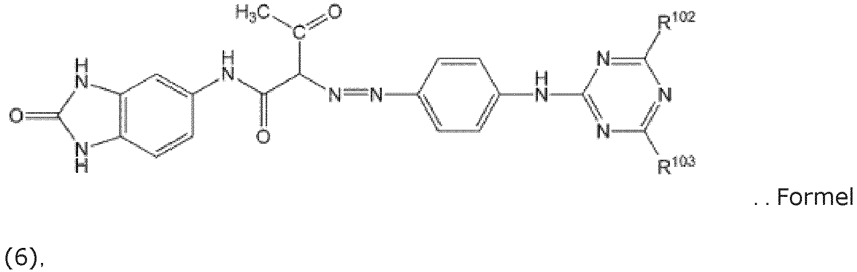 wobei R¹⁰¹ in den Formeln (3) bis (5) einen Substituenten wie folgt darstellt:
in Formel (3-1), (4-1) und (5-1), R¹⁰¹ = 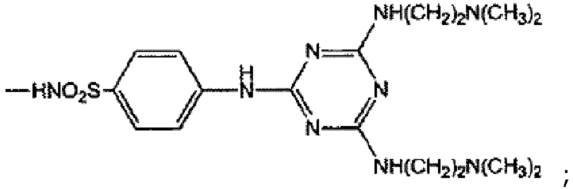
in Formel (3-2), (4-2) und (5-2), R¹⁰¹ = 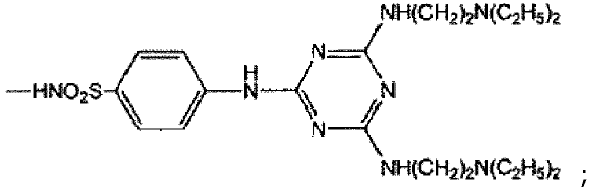
in Formel (3-3), (4-3) und (5-3), R¹⁰¹ = 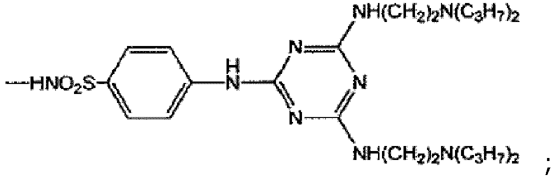
in Formel (3-4), (4-4) und (5-4), R¹⁰¹ = 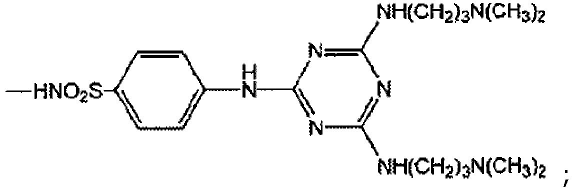
in Formel (3-5), (4-5) und (5-5), R¹⁰¹ = 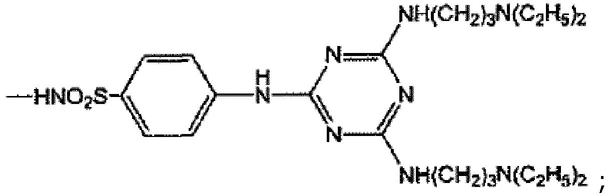
in Formel (3-6), (4-6) und (5-6), R¹⁰¹ = 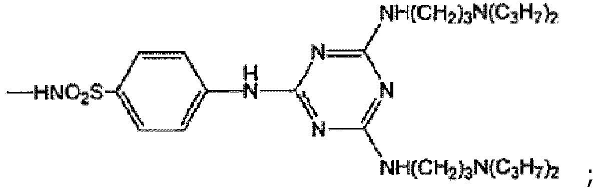
in Formel (3-7), (4-7) und (5-7), R¹⁰¹ = 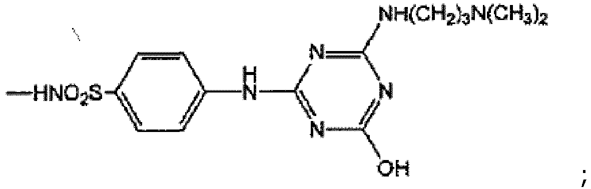
in Formel (3-8), (4-8) und (5-8), R¹⁰¹ = 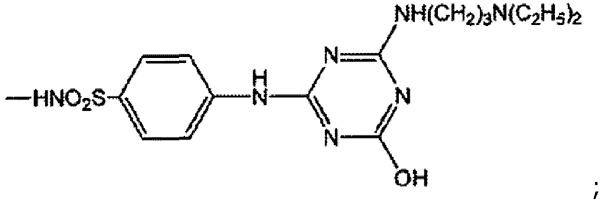
in Formel (3-9), (4-9) und (5-9), R¹⁰¹ = 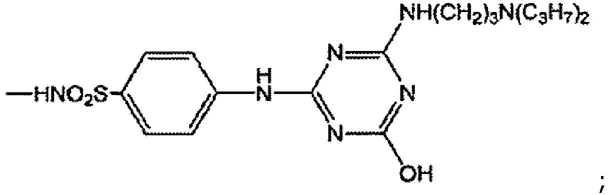
in Formel (3-10), (4-10) und (5-10), R¹⁰¹ = 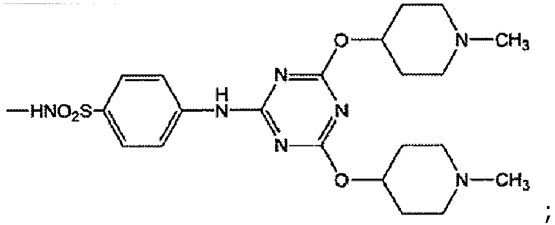 und wobei R¹⁰² und R¹⁰³ in Formel (6) Substituenten wie folgt darstellen:
in Formel (6-1), R¹⁰² = NH(CH₂)₃N(C₂H₅)₂ und R¹⁰³ = OH;
in Formel (6-2), R¹⁰² = NH(CH₂)₃N(C₂H₅)₂ und R¹⁰³ = OCH₃;
in Formel (6-3), R¹⁰² = NH(CH₂)₃N(C₂H₅)₂ und R¹⁰³ = NH(CH₂)₃N(C₂H₅)₂;
in Formel (6-4), R¹⁰² = NH(CH₂)₃N(C₃H₇)₂ und R¹⁰³ = NH(CH₂)₃N(C₃H₇)₂;
in Formel (6-5), R¹⁰² = NH(CH₂)₃N(C₄H₉)₂ und R¹⁰³ = NH(CH₂)₃N(C₄H₉)₂.

2. Färbezusammensetzung nach Anspruch 1,
wobei das organische Pigment (A) ein grünes Pigment (a1) enthält.

3. Färbezusammensetzung nach Anspruch 2,
wobei das grüne Pigment mindestens eines ausgewählt aus Pigment Green 7, Pigment Green 36 und Pigment Green 58 enthält.

4. Färbezusammensetzung nach einem der Ansprüche 1 bis 3,
wobei das Dispersionsmittel (b1) mit der sauren funktionellen Gruppe einen Bereich (b1-A) aufweist, der durch Polymerisation eines ethylenisch ungesättigten Monomers, das ein (Meth)acrylat enthält, gebildet wird, und
wobei ein theoretischer Wert einer Glasübergangstemperatur des Bereichs (b1-A) mindestens 40°C beträgt.

5. Färbezusammensetzung nach Anspruch 4,
wobei die saure funktionelle Gruppe eine aromatische Carboxylgruppe ist.

6. Verfahren zur Herstellung eines Farbfilters für ein Festkörperabbildungselement, wobei das Verfahren umfasst:
einen Schritt (X) des Bildens einer gefärbten Schicht unter Verwendung der Färbezusammensetzung nach einem der Ansprüche 1 bis 5; und
einen Schritt (Y) des Strukturierens der gefärbten Schicht durch Trockenätzung.

7. Verfahren zur Herstellung eines Farbfilters für ein Festkörperabbildungselement nach Anspruch 6,
wobei der Schritt (X) beinhaltet
einen Schritt (X-1) des Bildens eines Beschichtungsfilms, der die Färbezusammensetzung enthält, und
einen Schritt (X-2) des Erhaltens der der gefärbten Schicht durch Thermohärtung des Beschichtungsfilms, und
wobei der Schritt (Y) beinhaltet
einen Schritt (Y-1) des Bildens einer Photoresistschicht auf der gefärbten Schicht,
einen Schritt (Y-2) des Erhaltens eines Resistmusters durch Strukturierung der Photoresistschicht durch Belichtung und Entwicklung,
einen Schritt (Y-3) des Bildens eines gefärbten Musters durch Strukturierung der gefärbten Schicht durch Trockenätzen unter Verwendung des Resistmusters als eine Ätzmaske, und
einen Schritt (Y-4) des Inkontaktbringens einer Abziehflüssigkeit mit dem Resistmuster, um das Resistmuster von dem gefärbten Muster zu entfernen.

8. Verfahren zur Herstellung eines Farbfilters für ein Festkörperabbildungselement nach Anspruch 7,
wobei die Abziehflüssigkeit mindestens einen Stoff enthält, der aus der Gruppe ausgewählt ist, die aus N-Methylpyrrolidon, Dimethylsulfoxid und Monoethanolamin besteht.

## Revendications

1. Composition colorante utilisée pour former un motif coloré d'un filtre de couleur pour un élément d'imagerie à semi-conducteurs, la composition colorante comprenant :
un pigment organique (A) ;
un dispersant (B) ;
un composé époxy (C) ;
un solvant (D) ; et
un dérivé de matière colorante (E),
dans laquelle une teneur en pigment organique (A) est d'au moins 50 % en masse par rapport à une teneur non volatile dans la composition colorante,
dans laquelle le dispersant (B) contient un dispersant (b1) ayant un groupe fonctionnel acide et/ou un dispersant (b2) ayant un groupe fonctionnel basique,
dans laquelle le composé époxy (C) est au moins un composé choisi dans le groupe constitué par l'éther polyglycidylique de glycérol, l'éther polyglycidylique de type bisphénol et l'éther polyglycidylique de type bisphénol hydrogéné, l'éther polyglycidylique de glycérol étant au moins un choisi parmi un éther diglycidylique de glycérol bifonctionnel représenté par la Formule Chimique (1) ci-dessous et un éther triglycidylique de glycérol trifonctionnel représenté par la Formule Chimique (2), et 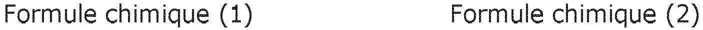 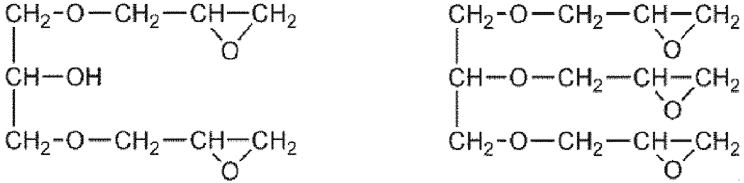
dans laquelle le dérivé de matière colorante (E) est un composé représenté par l'une quelconque des Formules (3-1) à (6-5) définies comme suit: 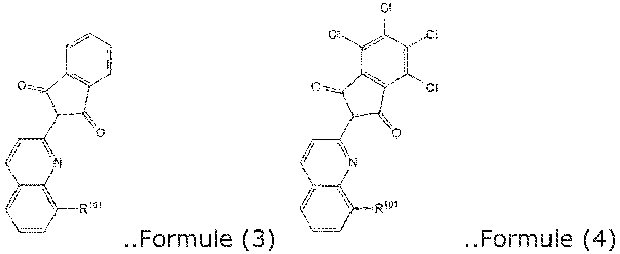 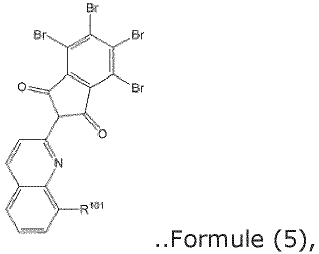 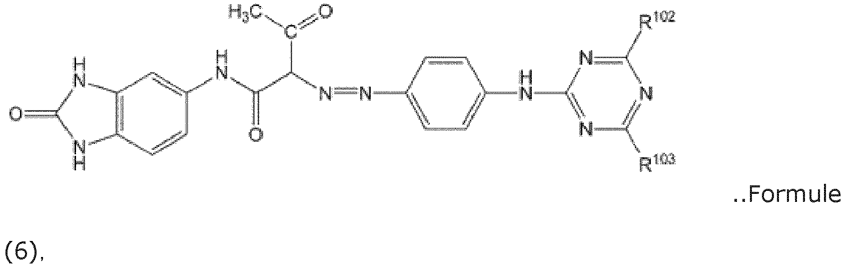 R¹⁰¹ dans les Formules (3) à (5) représentant un substituant comme suit :
dans les Formules (3-1), (4-1) et (5-1), R¹⁰¹ = 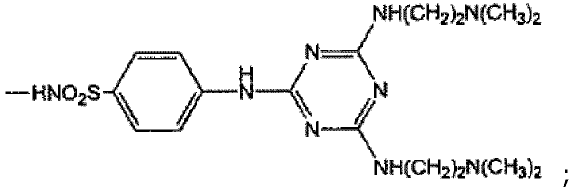
dans les Formules (3-2), (4-2) et (5-2), R¹⁰¹ = 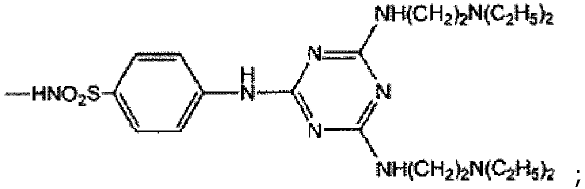
dans les Formules (3-3), (4-3) et (5-3), R¹⁰¹ = 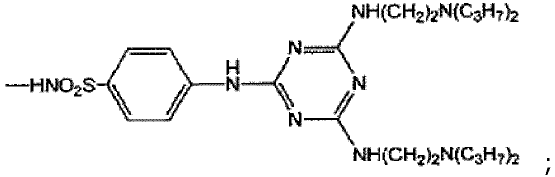
dans les Formules (3-4), (4-4) et (5-4), R¹⁰¹ = 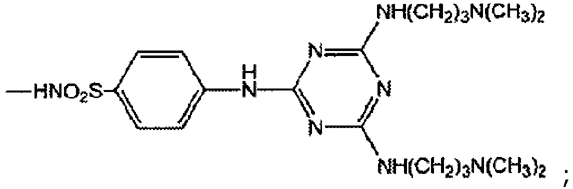
dans les Formules (3-5), (4-5) et (5-5), R¹⁰¹ = 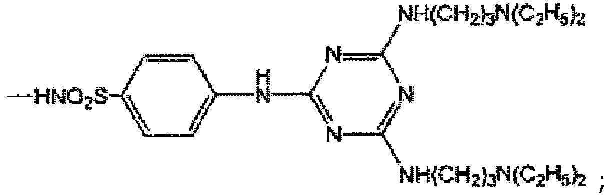
dans les Formules (3-6), (4-6) et (5-6), R¹⁰¹ = 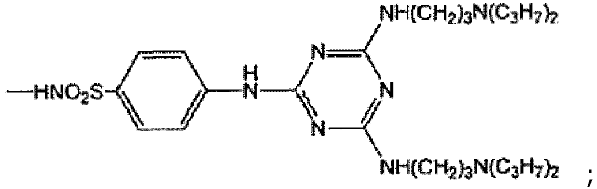
dans les Formules (3-7), (4-7) et (5-7), R¹⁰¹ = 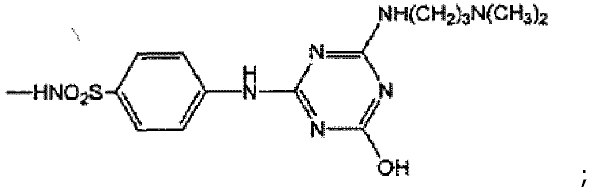
dans les Formules (3-8), (4-8) et (5-8), R¹⁰¹ = 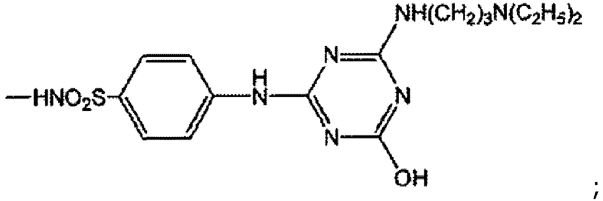
dans les Formules (3-9), (4-9) et (5-9), R¹⁰¹ = 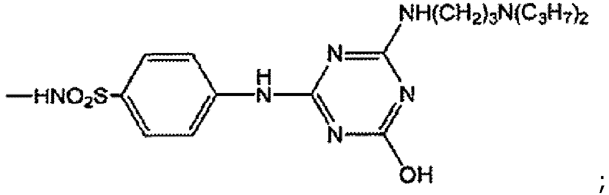
dans les Formules (3-10), (4-10) et (5-10), R¹⁰¹ = 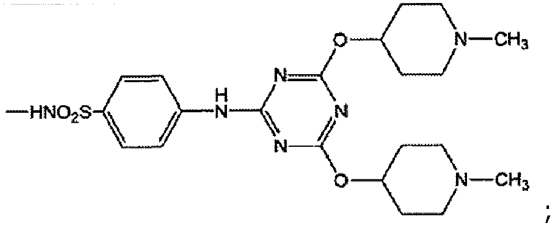 et R¹⁰² et R¹⁰³ dans la Formule (6) représentant des substituants comme suit :
dans la Formule (6-1), R¹⁰²= NH(CH₂)₃N(C₂H₅)₂ et R¹⁰³ = OH ;
dans la Formule (6-2), R¹⁰²= NH(CH₂)₃N(C₂H₅)₂ et R¹⁰³ = OCH₃ ;
dans la Formule (6-3), R¹⁰²= NH(CH₂)₃N(C₂H₅)₂ et R¹⁰³ = NH(CH₂)₃N(C₂H₅)₂ ;
dans la Formule (6-4), R¹⁰²= NH(CH₂)₃N(C₃H₇)₂ et R¹⁰³ = NH(CH₂)₃N(C₃H₇)₂ ;
dans la Formule (6-5), R¹⁰²= NH(CH₂)₃N(C₄H₉)₂ et R¹⁰³ = NH(CH₂)₃N(C₄H₉)₂.

2. Composition colorante selon la revendication 1,
dans laquelle le pigment organique (A) contient un pigment vert (a1).

3. Composition colorante selon la revendication 2,
dans laquelle le pigment vert contient au moins un choisi parmi le Pigment Green 7, le Pigment Green 36, et le Pigment Green 58.

4. Composition colorante selon l'une quelconque des revendications 1 à 3,
dans laquelle le dispersant (b1) ayant le groupe fonctionnel acide a une région (b1-A) formée par la polymérisation d'un monomère éthyléniquement insaturé contenant un (méth)acrylate, et
dans laquelle une valeur théorique d'une température de transition vitreuse de la région (b1-A) est d'au moins 40°C.

5. Composition colorante selon la revendication 4,
dans laquelle le groupe fonctionnel acide est un groupe carboxyle aromatique.

6. Procédé de production d'un filtre de couleur pour un élément d'imagerie à semi-conducteurs, le procédé comprenant :
une étape (X) de formation d'une couche colorée en utilisant la composition colorante selon l'une quelconque des revendications 1 à 5 ; et
une étape (Y) de modelage de la couche colorée par gravure à sec.

7. Procédé de production d'un filtre de couleur pour un élément d'imagerie à semi-conducteurs selon la revendication 6,
dans lequel l'étape (X) comprend
une étape (X-1) de formation d'un film de revêtement contenant la composition colorante, et
une étape (X-2) d'obtention la couche colorée par thermodurcissement du film de revêtement, et
dans lequel l'étape (Y) comprend
une étape (Y-1) de formation d'une couche de résine photosensible sur la couche colorée,
une étape (Y-2) d'obtention un motif de réserve en modelant la couche de résine photosensible par exposition et développement,
une étape (Y-3) de formation un motif coloré en modelant la couche colorée par gravure à sec en utilisant le motif de réserve comme masque de gravure, et
une étape (Y-4) de mise en contact d'un liquide de décapage avec le motif de réserve afin d'enlever le motif de réserve du motif coloré.

8. Procédé de production d'un filtre coloré pour un élément d'imagerie à semi-conducteurs selon la revendication 7,
dans lequel le liquide de décapage contient au moins un choisi dans le groupe constitué par la N-méthylpyrrolidone, le sulfoxyde de diméthyle et la monoéthanolamine.
